# EUROPEAN PATENT SPECIFICATION

(11) **EP 0 882 361 B1**
(45) Date of publication and mention of the grant of the patent: **22.10.2003**
(21) Application number: 96926699.8
(22) Date of filing: 27.06.1996
(51) Int. Cl.: H04N 7/10, H03H 11/34, H04H 1/02, H04B 3/04, H04N 7/22

(54) **WIDEBAND SIGNAL DISTRIBUTION SYSTEM**
VERTEILUNGSSYSTEM FÜR BREITBANDSIGNALE
SYSTEME DE REPARTITION DES SIGNAUX EN BANDE LARGE

(30) Priority: 28.06.1995 US 495136; 25.10.1995 US 548036; 25.10.1995 US 548038; 30.01.1996 US 10857
(43) Date of publication of application: 09.12.1998
(73) Proprietor: THE WHITAKER CORPORATION, Wilmington, Delaware 19808 (US)
(72) Inventor: FLICKINGER, Steven, Lee, Hummelstown, PA 17036 (US); FETTEROLF, James, Ray, Mechanicsburg, PA 17055 (US); PRESCHUTTI, Joseph, P., State College, PA 16803 (US); BOWEN, Terry, P., Etters, PA 17319 (US); LEGG, Jeff, State College, PA 16801 (US); KOLLER, David, Phillip, State College, PA 16801 (US)
(74) Representative: Warren, Keith Stanley
(86) International application number: US9611191
(87) International publication number: WO97001931

(56) References cited:
- EP-A- 0 496 422
- FR-A- 2 626 119
- GB-A- 2 173 077
- GB-A- 2 178 274
- GB-A- 2 263 604
- US-A- 5 485 630
- US-A- 5 528 283

## Description

This invention is directed to a wideband signal distribution system, where the transmission medium way be selected from the class of products comprising twisted pair, coaxial cable, fiber optic cable, and combinations thereof. A preferred system is one which incorporates twisted pair as the primary distribution medium. In a combination system, for example, distribution units can be cascaded utilizing coaxial cable or optical fiber cable to enhance the functionality of the system.

There are numerous instances where it is desired to distribute over twisted pair coaxial cable, or fiber optic cable wire, within a relatively local area, such as a single building, wideband signals modulated onto RF carriers. An example of a distribution system which accepts wideband TV and FM radio signals and a separate local video recorder signal within a narrow band is disclosed in French Patent application FR - A - 2626 119. The signals are fed to a mixer stage via impedance-matching amplifiers and then distributed to a plurality of output drives.

A particular application is the distribution of video signals. For example, a school may have a number of classrooms and administrative offices, each having a television monitor, and it may be desired at a given time to provide a program to all of the classrooms and offices, originating either from a source within one of the classrooms or offices, such as a VCR, or from an outside source, such as a local cable system. Similarly, a corporation may have a building, or several closely spaced buildings, with numerous conference rooms equipped with television monitors and analogous program presentations may be desired. It is therefore a primary object of the present invention to provide cabling infrastructure for distributing wideband signals within a relatively local area.

Such cabling infrastructure should preferably possess certain attributes. For example, it should be relatively inexpensive. Further, it should be readily expandable. It is therefore a more specific object of this invention to provide such cabling infrastructure which possesses those attributes.

New construction is commonly pre-cabled by the local telephone company. Typically, Category 5 twisted pair cable is utilized for such pre-cabling. This cable includes four twisted pairs within its sheath. Category 5 twisted pair wire is capable of carrying wideband signals thereover. Accordingly, using pre-installed twisted pair wire as part of the desired cabling infrastructure would be cost effective. It is therefore a further object of the present invention to provide a cabling system for distributing wideband signals which preferably incorporate category 5 twisted pair wire.

In such cabling system, outlets at various locations would be connected by twisted pair wire cables to concentrators, or distribution units, which interconnect the various outlets. It is therefore another object of the present invention to provide such a distribution unit which is adaptable so that it can be used singly when the number of outlets in the system is within the capacity of a single distribution unit, or which can be used in a multiple configuration cascaded with other such distribution units to expand the system beyond the capacity of a single distribution unit. Further, such cascading may also be done with twisted pair wire cable, coaxial cable, or optical fiber cable.

A problem exists, however, when it is desirable to distribute wideband modulated signals to many classrooms or locations. As the number of classrooms increases the number of input and output locations increases, and the amount of near end cross talk also increases. This is due to increased length of cable in the system necessary to support the increased number of classrooms. Near end cross talk occurs as a result of capacitive coupling of signals between the input wires and output wires of each outlet. It is therefore another object of this invention to reduce near and cross talk in a broadband distribution system having many input and output ports.

Another problem exists when many outlets are present in the distribution system in that the distance between each distribution unit and outlet is variable. Outlets which are further from the distribution unit will necessarily contain longer lengths of cable between the distribution unit and the outlet. This results in signal attenuation levels at each outlet being different based on the distance each outlet is from the distribution unit. It is therefore another object of this invention to provide a circuit which simulates long and short lengths of cable in order to provide consistent system signal alternation levels at each outlet.

The foregoing and additional objects are substantially attained in accordance with the principles of this invention by providing a wideband signal distribution system which functions as "passive" infrastructure to distribute wideband signals modulated onto RF carriers within a specified frequency band among a plurality of outlets.

According to one aspect, the invention consists in a system for distributing wideband signals modulated onto RF carriers within a specified frequency band among a plurality of outlets, each outlet being connected to a source or destination of the wideband signals, the system comprising a
distribution unit including:
a plurality of input ports;
a plurality of output ports;
a transmission path;
combiner means for applying signals appearing at said plurality of input ports to said transmission path; and
splitter means for applying signals appearing on said transmission path to all of said plurality of output ports; the system characterized by;
a plurality of cables selected from the class consisting of fiber optic cable, coaxial cable, and twisted pair wire cable, and extending between a respective one of said distribution unit ports and a respective one of said plurality of outlets; and further characterised in that the distribution unit includes
a signal inlet;
a signal outlet;
switch means operable to either a first state or a second state, said switch means when in its first state being effective to couple said transmission path to said combiner means and to said splitter means, and said switch means when in its second state being effective to couple said combiner means to said signal outlet instead of to said transmission path and to couple said splitter means to said signal inlet instead of to said transmission path; and
a plurality of impedance matching devices, each of said devices terminating a respective end of a respective one of said cables,
the system being still further characterised in that it Includes first and second said distribution units with one of the output ports of the first distribution unit being connected to the signal inlet of the second distribution unit and one of the input ports of the first distribution unit being connected to the signal outlet of the second distribution unit, the switch means of the first distribution unit being in its first state, and the switch means of the second distribution unit being in its second state.

According to another aspect, the invention consists in a distribution unit for use in a wideband signal distribution system, where the system includes a plurality of outlets each outlet being connected to a source or a destination of wideband signals, and a plurality of cables extending between the outlets and the distribution unit for carrying wideband signals modulated onto RF carriers within a specified frequency band between the outlets, the distribution unit comprising
a plurality of input ports each adapted to be connected to a respective one of said cables;
a plurality of output ports; a combiner having a plurality of input terminals and having an output terminal to which is applied a combined signal which is an additive combination of all signals appearing at said input ports;
a splitter having an input terminal and a plurality of output terminals to all of which is applied a signal appearing at the splitter input terminal;
a transmission path coupled between said combiner output terminal and said splitter input terminal;
characterised by;
a first plurality of impedance matching devices each having its balanced end connected to a respective one of said input ports;
a second plurality of impedance matching devices each having its unbalanced end connected to a respective one of said splitter output terminals;
a signal inlet adapted to be coupled to a cable extending to an output port of another distribution unit of identical construction;
a signal outlet adapted to be coupled to a cable extending to an input port of said another distribution unit; and
switch means operable to either a first state or a second state, said switch means being coupled to said transmission path, said combiner output terminal, said splitter input terminal, said signal inlet and said signal outlet, said switch means when in its first state being effective to couple said transmission path to said combiner output terminal and said splitter input terminal, and said switch means when in its second state being effective to couple said combiner output terminal to said signal outlet and to couple said signal inlet to said splitter input terminal;
and further characterised in that each combined input terminal is connected to the unbalanced end of a respective one of said first plurality of impedance matching devices;
each output port connected to the balanced end of a respective one of said second plurality of impedance matching devices and each is adapted to be connected to a respective one of said cables;
The first distribution unit is therefore considered to be operating in the "master" mode and the second distribution unit is considered to be operating in the "slave" mode.

According to a feature of a preferred embodiment of the inventions each of the distribution units further includes an oscillator for providing an oscillating pilot signal at a fixed frequency outside the specified frequency band of the RF carriers, first controllable gain means interposed between the switch means and the signal outlet, and second controllable gain means interposed between the signal inlet and the switch means. When the switch means is in its first state, it further couples the oscillator to the transmission path, and each of the distribution units further includes gain control means responsive to the level of the pilot signal for controlling the gain of both the first and second gain means.

Preferably, the switch means in each of the distribution units defaults to its first state and is responsive to the appearance of the pilot signal at the signal input for changing to its second state.

There may also be provisions of incorporating into the system the use of coaxial cable, fiber optic cable, and combinations thereof with or without the traditional twisted wire pairs. This added dimension to the invention allows for the potential for a more expansive system, such as in a broad complex - a university campus being a prime example

A switchable impedance circuit may be provided for simulating various lengths of cable in order to achieve a desired attenuation level at each outlet.

Furthermore, an enabling circuit may be provided which comprises an input port to receive a baseband source signal, a transmission path between the input port and the output port, at least one impedance matching device, a power source connected to the impedance matching device which combines a biasing signal with the input signal in order to operate a diode switch which is connected to the output of the impedance matching device at the input of the distribution unit.

The invention will now be described by way of example with reference to the accompanying drawings which:
FIGURE 1 is a pictorial representation of a cabling system constructed in accordance with the principles of this invention, illustratively for distributing video signals;
FIGURE 2 is a block diagram of an inventive distribution unit for the system of Figure 1;
FIGURES 3 and 4 together illustrate the cascading of a pair of the distribution units shown in Figure 2, showing one of the distribution units operating in the master mode and the other distribution unit operating in the slave mode, respectively;
FIGURES 3A and 4A are block diagrams similar to Figures 3 and 4, showing, however, the incorporation of fiber optic cable into the distribution system of this invention.
FIGURES 5-9 together form a detailed electrical schematic circuit diagram of an illustrative embodiment of the distribution unit shown in Figure 2;
FIGURE 10 illustrates how the cabling system according to the present invention accommodates different lengths of twisted pair wire cable.
FIG. 11 is a block diagram of an enabling and switchable cable simulator circuit.
FIG. 12 is a schematic of the cable simulator circuit of FIG. 11.

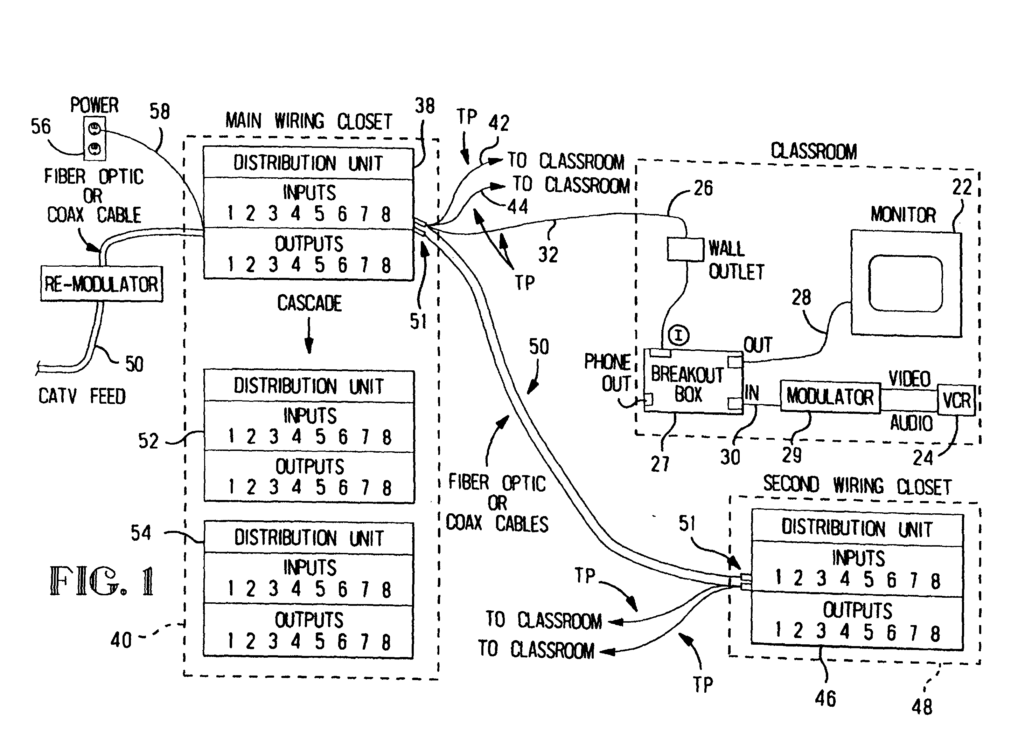

Figure 1 represents in pictorial fashion a preferred cabling system according to the present invention installed within a school environment. For purposes of illustration, the system disclosed herein distributes video signals, but this invention can be utilized for distributing other wideband signals. As shown, a typical classroom 20 has a television monitor 22 and a source of video signals, illustratively a VCR, 24. The monitor 22 is connected to a wall outlet 26 by the coaxial cable 28. The VCR 24 is connected to the wall outlet 26 through the modulator 29 and the coaxial cable 30. Each of the cables 28, 30 is preferably connected to a respective twisted pair wire within the twisted pair cable 32 by means of a respective impedance matching device, or balun 34, 36, as hereinafter explained.

The twisted pair wire cable 32 is connected to input and output ports of the distribution unit 38 situated in the wiring closet 40. The distribution unit 38 is connected to additional classrooms via the twisted pair wire cables 42, 44 and is cascaded to another distribution unit 46 in a second wiring closet 48 by either coaxial cables or fiber optic cables 50 connected to the distribution unit 38 through impedance matching devices (IMDs) 51, such as a transformer for coaxial cable, an optoelectronic transceiver for fiber optic cable, or a balun for twisted pair wire cable. It will be understood, as indicated previously, that twisted pair wire cable could be utilized depending upon the distance between the wiring closets 40, 48. In any case, the distribution unit 46 is in turn connected to outlets in other classrooms preferably by respective twisted pair wire cables. Further, the distribution unit 38 may be cascaded to the distribution units 52, 54 within the same wiring closet 40.

The distribution unit 38 receives power from a standard power wall outlet 56 over the power cable 58. The other distribution units receive their power in a similar manner. In addition to the cabling system receiving video signals from an internal source such as the VCR 24 in the classroom 20, it may also receive video signals from an external source, such as a local cable TV system over the coaxial cable or optical fiber cable 50. Also, one or more classrooms or administrative offices in the school could have a video camera as a video signal source. As known, the video signals are modulated onto RF carriers within a specified frequency band.

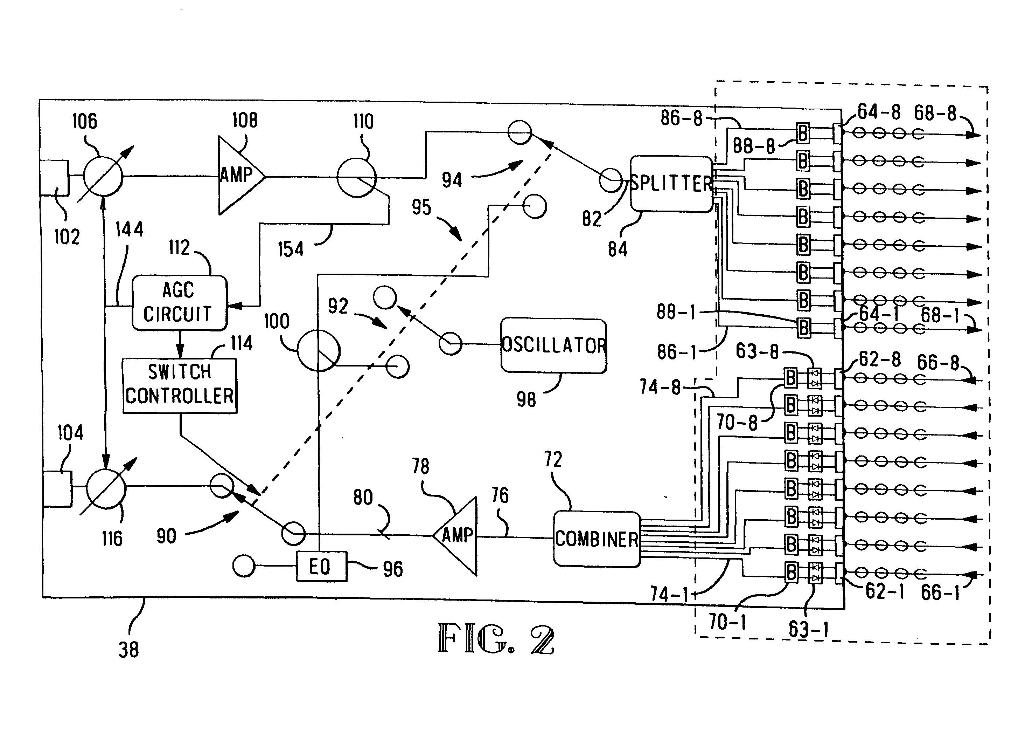

As will be described in full detail hereinafter, each of the distribution units 38, 46, 52, 54 has eight input ports and eight output ports. If there are only eight outlets in the system, then a single distribution unit 38 can accommodate all the outlets. However, for more than eight outlets, at least one more distribution unit cascaded to the distribution unit 38 is required. In this situation, the distribution unit 38 is considered to be a "master" unit and the additional distribution unit is considered to be a "slave" unit. An attribute of the present invention is that the distribution units are identical and automatically configure themselves to operate either in the master mode or in the slave mode. Referring to Figure 2, shown therein is a block diagram of a distribution unit 38 constructed in accordance with the principles of this invention and which may be utilized in the cabling system shown in Figure 1. The distribution unit 38, utilizing twisted pair wire cable, includes eight input ports 62-1, 62-2, 62-3, 62-4, 62-5, 62-6, 62-7, 62-8 and eight output ports 64-1, 64-2, 64-3, 64-4, 64-5, 64-6, 64-7, 64-8. Each of the ports 62, 64 is adapted for connection to the two wires of a respective twisted pair 66, 68. The incoming signals at the input ports 62 are balanced signals (a characteristic of signals transmitted over twisted pair wire) and are coupled through respective baluns 70-1, 70-2, 70-3, 70-4, 70-5, 70-6, 70-7, 70-8 to the combiner circuit 72. The combiner circuit 72 is effective to additively combine, in a passive manner, all of the signals appearing at its inputs 74-1, 74-2, 74-3, 74-4, 74-5, 74-6, 74-7, 74-8 and provide a combined additive signal on its output lead 76. The output lead 76 is connected to the input of the amplifier 78, whose output lead 80 is connected to one part of a master/slave switch, to be described in full detail hereinafter.

Analogously, signals appearing on the input lead 82 to the splitter circuit 84 are passed through the splitter circuit 84 and provided, in unmodified form except for some attenuation, at the splitter outputs 86-1, 86-2, 86-3, 86-4, 86-5, 86-6, 86-7, 86-8. These signals are provided as inputs to the respective baluns 88-1, 88-2, 88-3, 88-4, 88-5, 88-6, 88-7, 88-8, which provide balanced signals to the output ports 64-1, 64-2, 64-3, 64-4, 64-5, 64-6, 64-7, 64-8 for subsequent transmittal in balanced form over the twisted pairs 68-1, 68-2, 68-3, 68-4, 68-5, 68-6, 68-7, 68-8.

Figure 2 illustrates the master/slave switch as having three parts 90, 92, 94, with all of the switch parts being shown in the "slave" position. The default state of the master/slave switch is to its master position, so that the amplifier output 80 is coupled through the switch part 90 to a transmission path 95 including the equalizer 96, which connects the amplifier output 80 to the splitter input 82, through the switch parts 90, 94. At the same time, the switch part 92 couples the output of the oscillator circuit 98 to the transmission path 95 through the directional coupler 100. Thus, when the distribution unit 38 is operated in the master mode, the signals appearing at the input ports 62 are combined, looped back, combined with an oscillator signal, and transmitted out all of the output ports 64.

If the number of outlets in a cabling system is more than the capacity of a single distribution unit, illustratively eight outlets, one or more additional distribution units may be cascaded from the master distribution unit by connecting one of the output ports 64 of the master distribution unit to the signal inlet 102 of a "downstream" distribution unit and by connecting one of the input ports 62 of the master distribution unit to the signal outlet 104 of the downstream distribution unit. Thus, when the distribution unit 38 is a downstream distribution unit, the signals appearing at the signal inlet 102 pass through the variable attenuator 106 and to the amplifier 108. Part of the output of the amplifier 108 is extracted by the directional coupler 110 and passed to the automatic gain control (AGC) circuit 112. It will be recalled that when the distribution unit 38 is operating in its master mode, the oscillator circuit 98 provides a signal which goes to all of the output ports 64. This signal is a fixed frequency oscillating pilot signal which is outside the specified frequency band of the RF carriers. This pilot signal is sensed by the AGC circuit 112 and is utilized to control the attenuation of the variable attenuator 106. In addition, the pilot signal is provided to the switch controller 114 which is responsive to the presence of the pilot signal for controlling the master/slave switch to change to the slave position (as illustrated in Figure 2). The output of the amplifier 108 then passes through the switch part 94 to the splitter circuit 84, from which it is applied to the output ports 64. Similarly, the output of the amplifier 78 passes through the switch part 90, through the variable attenuator 116, to the signal outlet 104, and from there to the upstream distribution unit. It is noted that the AGC circuit 112 controls the attenuation of the variable attenuator 116, as well as the variable attenuator 106. It is also noted that when the distribution unit 38 is in the slave mode, the oscillator circuit 98 is isolated and does not provide a pilot signal to the cabling system. Although variable attenuators 106, 116 have been illustrated, other controllable gain devices can be utilized.

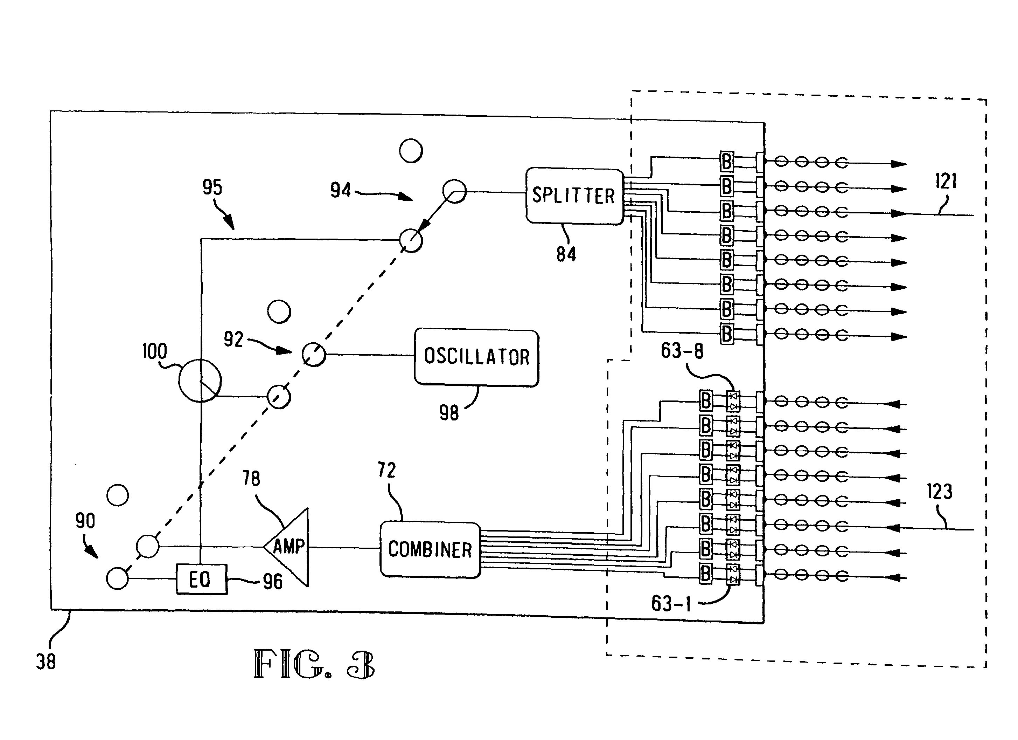

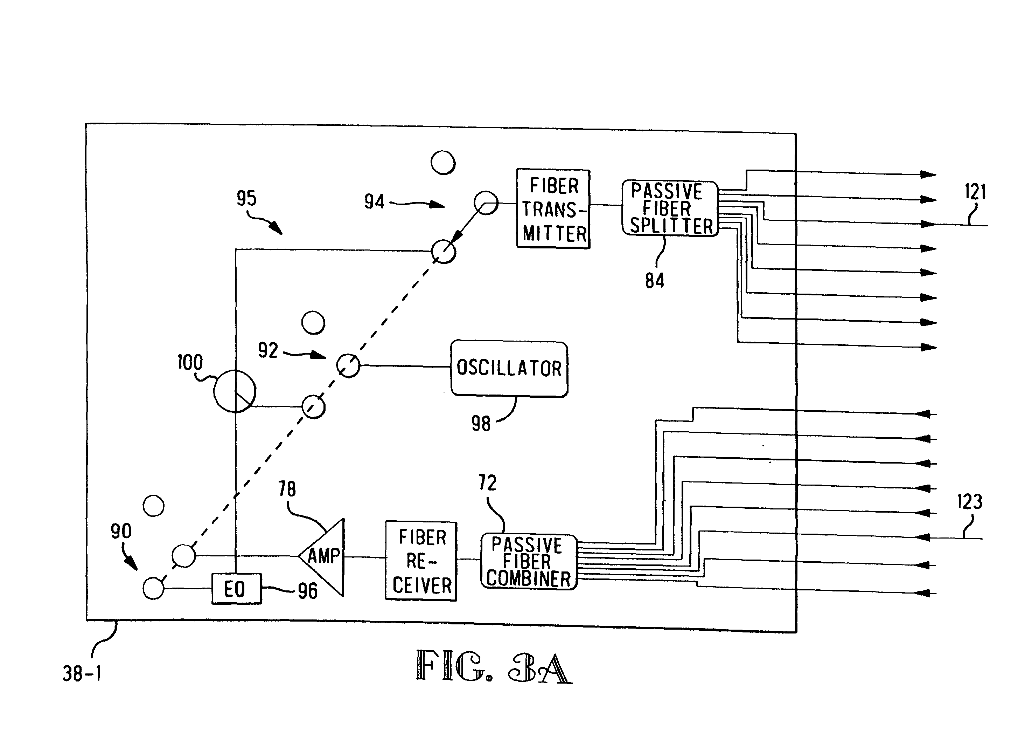

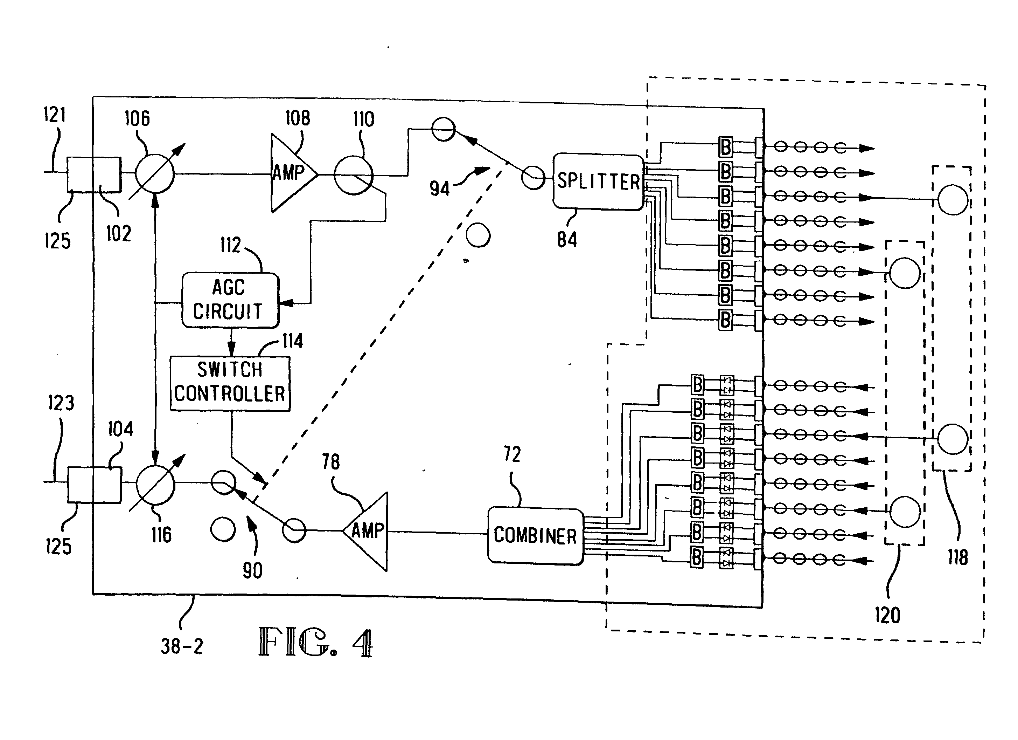

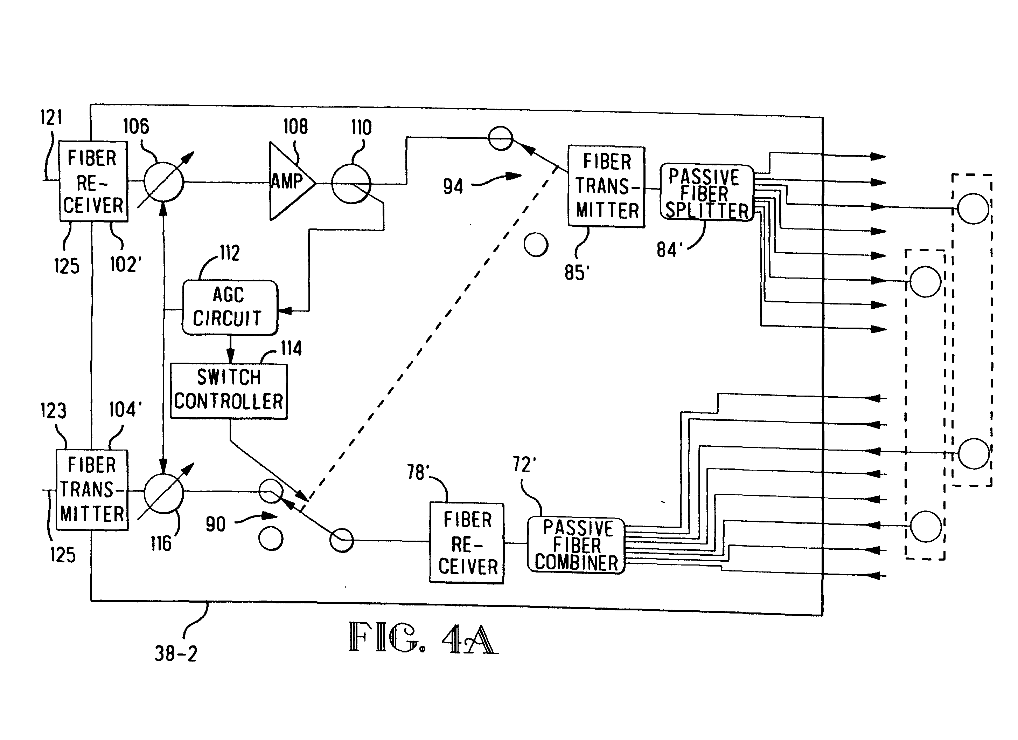

Figures 3 and 4 together illustrate a pair of identical distribution units 38 cascaded together, with the distribution unit 38-1 operating in the master mode and the distribution unit 38-2 being downstream and operating in the slave mode. Only those operative portions of the distribution units 38-1, 38-2 are illustrated in Figures 3 and 4. The distribution unit 38-2 is shown as being coupled to the two outlets 118,120 and the distribution unit 38-1 is shown as being coupled only to the distribution unit 38-2 via the twisted pairs 121, 123. However, it is understood that the remaining input/output ports of the two distribution units 38-1, 38-2 may be connected to additional outlets. Although twisted pairs 121, 123 are shown, it is understood that coaxial cables or optical fiber cables may be used instead. Figures 3A and 4A, companion block diagrams to Figures 3 and 4 respectively, represent a distribution unit where fiber optic cable may be incorporated into the system. In Figures 3A and 4A, like reference numerals are the same components identified with Figures 3 and 4, and the "prime" reference numerals represent functionally equivalent components suitable for fiber optic cable, for example. For the latter situation, reference numeral 72' is a passive fiber combiner, 78' a fiber optic receiver, 84' a passive fiber splitter, 85' a fiber optic transmitter, 102' a fiber optic receiver, and 104' a fiber optic transmitter. In any event, an impedance matching device (IMD) may be required for transforming between the balanced signals at distribution unit 38-1 and the unbalanced signals at distribution unit 38-2. Thus, when twisted pair wire cables are used, the baluns 125 are at the input to the distribution unit 38-2.

Thus, as shown in Figures 3 and 4, a signal originating from the outlet 120 enters the distribution unit 38-2, passes through the combiner circuit 72, the amplifier 78, the switch part 90, the variable attenuator 116 and enters the distribution unit 38-1. The signal then passes through the combiner circuit 72, the amplifier 78, the switch part 90 and the transmission path 95. In the directional coupler 100, the signal has added to it the pilot signal from the oscillator 98. This combined signal then passes through the switch part 94, the splitter circuit 84, exits the distribution unit 38-1 and enters the distribution unit 38-2. The combined signal then passes through the variable attenuator 106 and the amplifier 108. The combined signal is passed to the AGC circuit 112 by the directional coupler 110, where the pilot signal is extracted and utilized to control the attenuation of the variable attenuators 106, 116 and also to insure that the master/slave switch in the distribution unit 38-2 is in the slave state. The remainder of the signal leaves the directional coupler 110 and passes through the switch part 94 and the splitter circuit 84, from which it exits the distribution unit 38-2 and is transmitted to the outlets 118, 120.

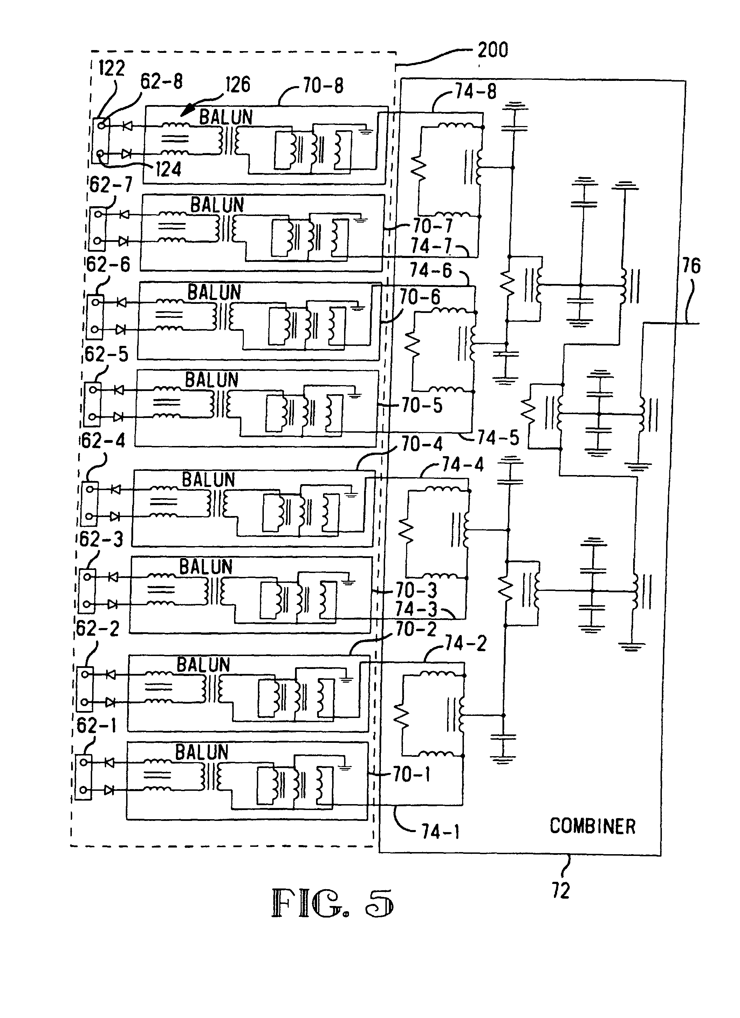

Figures 5-9 show a preferred illustrative circuitry which may be utilized for the distribution unit 38. Figure 5 illustrates the input ports 62, the baluns 70 and the combiner circuit 72. As shown, each of the input ports 62 has a pair of input terminals 122, 124 adapted to be connected to a respective one of the wires making up a respective twisted pair 66. The input terminals 122, 124 are connected through a common mode choke 126 to the remainder of the balun circuitry 70, which is made up of inductively coupled coils, as is conventional and well known in the art. Thus, the balanced end of each of the baluns 70 is coupled to a respective one of the input ports 62 and the unbalanced end of each of the baluns 70 is connected to a respective one of the inputs 74 to the combiner 72. The combiner 72 is unpowered and comprised of passive elements (transformers, resistors, inductors, and capacitors) which additively combine signals on the inputs 74 to provide a combined additive signal on the output lead 76.

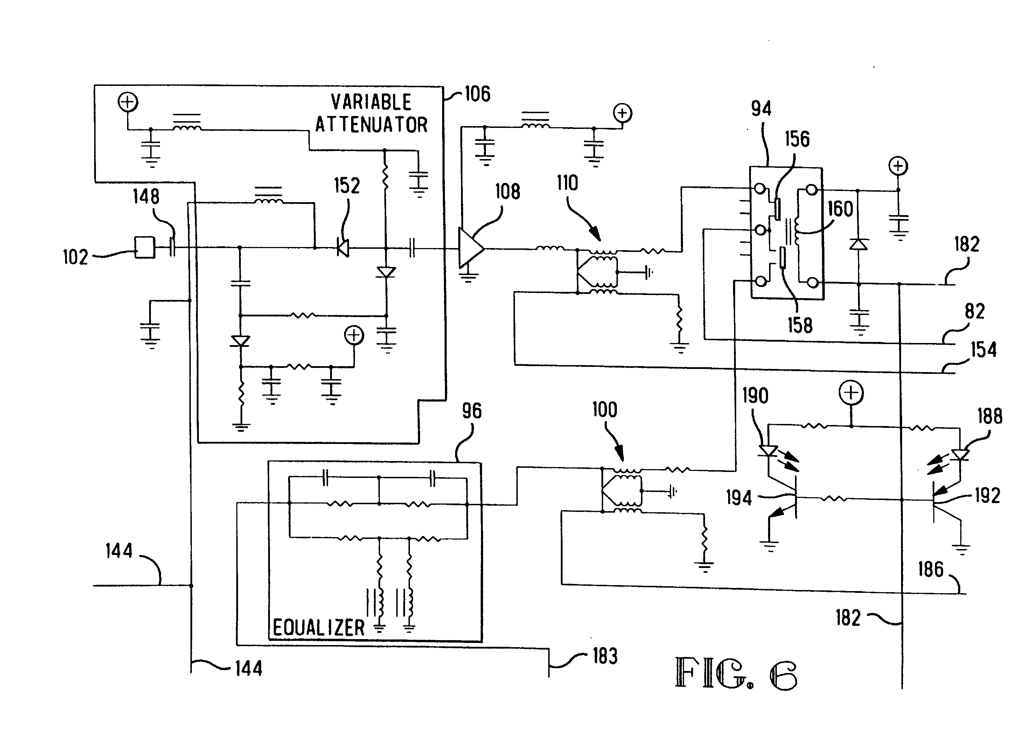

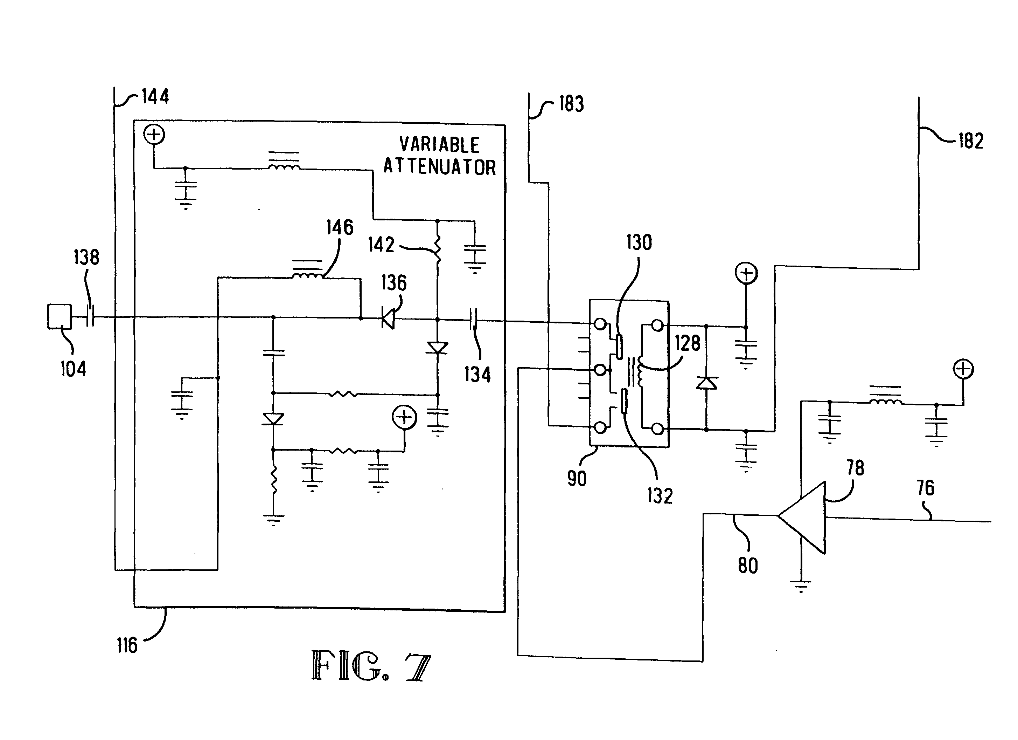

Referring to Figures 6 and 7, the combiner output 76 is applied as the input to the amplifier 78, which is illustratively a Motorola MHW1222 CATV RF hybrid amplifier. The output of the amplifier 78 on the lead 80 goes to the switch part 90, which is illustratively a single pole double throw type relay switch having an energizing coil 128. The state of the switch 90 illustrated in Figure 7 is the slave mode state, which is the state of the switch 90 when there is no power applied to the distribution unit 60. In this state, the contact 130 is closed and the contact 132 is open. However, as will be described in full detail hereinafter, when power is applied to the distribution unit 60, the switch 90 reverts to the master mode state where the contact 132 is closed and the contact 130 is open.

With the distribution unit 38 in the slave mode and with the contact 130 being closed, the output of the amplifier 78 on the lead 80 is coupled to the input of the variable attenuator 116, which includes a p-i-n diode 136. The cathode of the diode 136 is coupled to the signal outlet 104 through the capacitor 138 and the anode of the diode 136 is coupled to the output 80 of the amplifier 78 through the capacitor 134 and the switch 90. In addition, the anode of the diode 136 is connected to a source of bias current through the resistor 142 and the cathode of the diode 136 is connected to the output lead 144 of the AGC circuit 112 through the inductor 146. As is known, the AGC circuit 112, by changing the voltage level on the output lead 144, varies the bias current through the diode 136 to control the attenuation on the signal passing therethrough.

The signal appearing at the signal inlet 102 of the distribution unit 38 is coupled through the capacitor 148 to the variable attenuator 106, which is of identical construction to the variable attenuator 116 and includes its respective p-i-n diode 152, whose cathode is coupled to the AGC circuit 112 output lead 144. The output of the variable attenuator 106 is connected to the input of the amplifier 108, which is illustratively of the same type as the amplifier 78. The output of the amplifier 108 passes through the directional coupler 110 which provides a portion of the signal on the lead 154 and passes the rest of the signal to the switch 94. The switch 94 is of the same construction as the switch 90 and includes a contact 156, a contact 158 and an energizing coil 160. With no power applied to the distribution unit 38, the state of the switch 90 is such that the contact 156 is closed and the contact 158 is open, which is the slave mode state of the switch 94. The default mode of this switch 94 when power is applied to the distribution unit 60 is the reverse, i.e., the contact 156 is open and the contact 158 is closed. With the contact 156 closed (the slave mode), the output of the amplifier 108, after passing through the directional coupler 110, is applied as the input to the splitter circuit 84 over the lead 82.

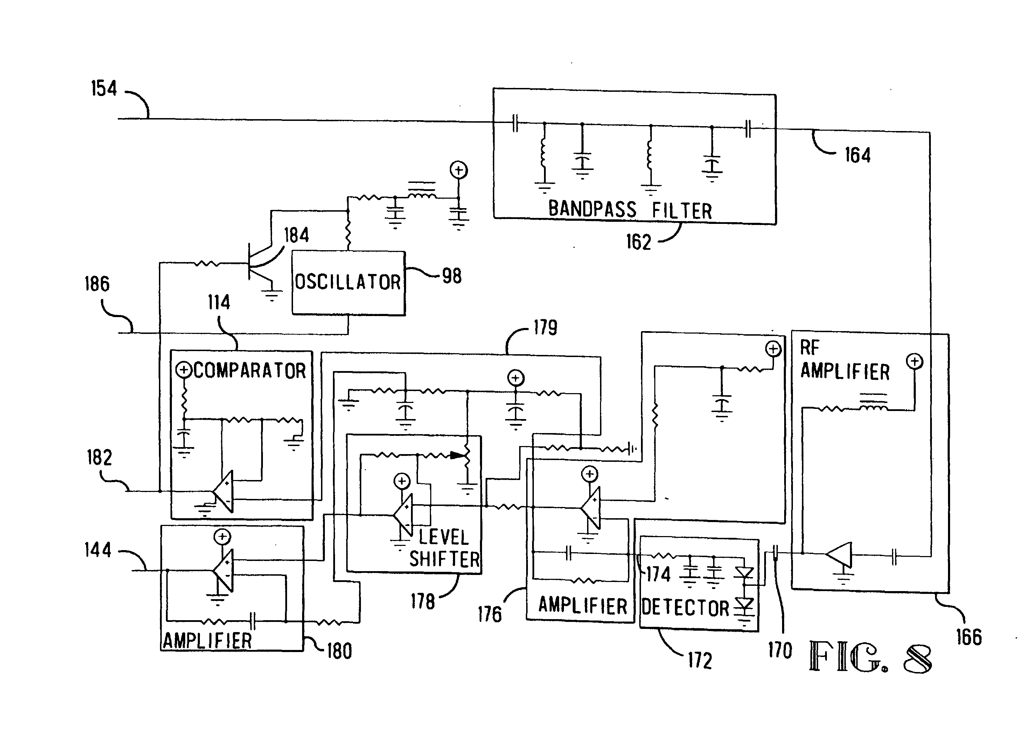

Referring now to Figure 8, the signal appearing on the lead 154 is provided as an input to the bandpass filter 162 which allows the pilot signal to pass therethrough and appear on the lead 164 and blocks the signals within the specified frequency band of the RF carriers. The pilot signal on the lead 164 is provided as an input to the RF amplifier stage 166 of the AGC circuit 112. The output of the RF amplifier stage 166 is coupled by the capacitor 170 to the detector stage 172, which provides an output signal on the lead 174 to the DC amplifier stage 176. The output of the detector stage 172 is a lower voltage when the pilot signal is present than when it is not present and the amplifier stage 176 is an inverting amplifier. The output of the amplifier stage 176 is provided as an input to the level shifter stage 178, whose output is provided to the further amplifier stage 180. The output of the amplifier stage 180 is the AGC output lead 144, which goes to the variable attenuators 106, 116.

The output of the amplifier stage 176, in addition to going to the level shifter stage 178, is provided as an input over the lead 179 to the switch controller 114, which is illustratively a comparator. The output of the switch controller 114 on the lead 182 is high if the pilot signal is present and is low if the pilot signal is not present. Thus, the voltage level on the lead 182 determines whether the distribution unit 38 is operating in the slave mode or in the master mode. Thus, when power is initially applied to a distribution unit 38, if no other distribution units are connected, then there will be no pilot signal and the voltage level on the lead 182 will be low. The lead 182 is connected to control the energization of the coils 128, 160 of the switches 90, 94, respectively. The low level of the lead 182 is the default state of the distribution unit 60 and causes the coils 128, 160 to be energized, closing the contacts 132, 158 and placing the distribution unit 38 in the master mode. In this master mode, the output of the amplifier 78 is passed through the switch 90 to the lead 183, and thence to the transmission path 95. The lead 182 is also connected to the gate of the transistor 184, which functions as the switch part 92 (Figure 2). With a low level on the lead 182, the transistor 184 is not conductive and power is applied to the oscillator circuit 98. Preferably, the oscillator circuit 98 is a fixed frequency crystal controlled oscillator which puts a fixed frequency oscillating signal on the lead 186. This signal goes through the directional coupler 100 to the transmission path 95 and then out to downstream distribution units, as described above.

In the downstream distribution units, the pilot signal is detected and the level of the lead 182 is high. This causes the transistor 184 to saturate and shunt the power away from the oscillator 98, thereby turning it off. In addition, the coils 128, 160 are not energized so that the contacts 130, 156 are closed, which is the slave mode of the distribution unit 38.

The distribution unit 60 further includes means for indicating whether the distribution unit 38 is operated in the master mode or the slave mode. Illustratively, this includes the light emitting diodes 188, 190 (Figure 6), which are controlled by the respective transistors 192, 194. When the distribution unit 38 is in the master mode, the lead 182 is low, causing the transistor 192 to conduct, thereby energizing the light emitting diode 188. When the distribution unit 60 is in the slave mode, the lead 182 is high, causing the transistor 194 to conduct, thereby energizing the light emitting diode 190.

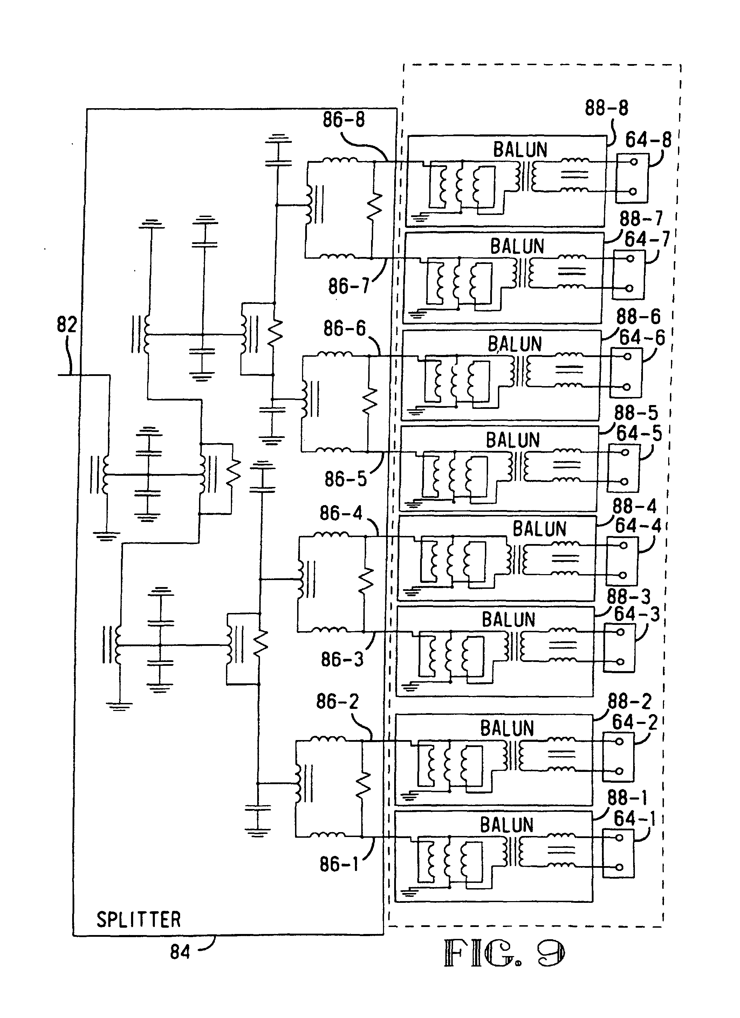

Figure 9 illustrates the splitter circuit 84, the output baluns 88 and the output ports 64. This circuitry is substantially the inverse of the input circuitry and the combiner shown in Figure 5.

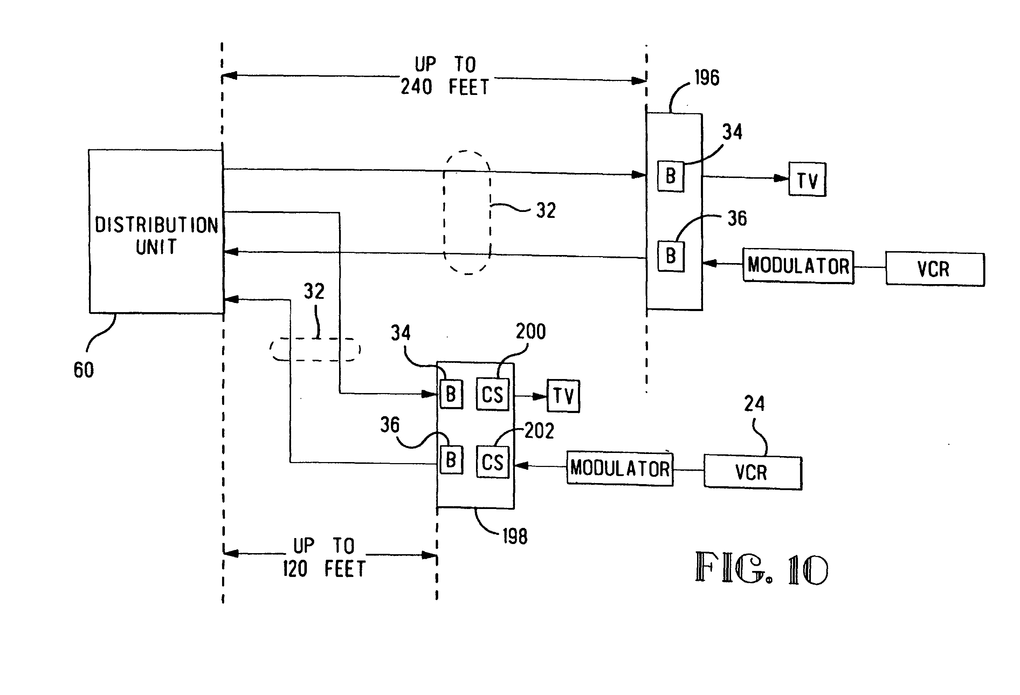

As mentioned above, an attribute of the present system is that identical distribution units 38 can be utilized, no matter where they are disposed in the system. Since the outlets can be located at different distances from a distribution unit, some means must be provided to accommodate the different attenuations inherent in different lengths of twisted pair wire cable 32. Such an accommodation is shown in Figure 10. Illustratively, the amplifications of the stages of the distribution unit 60 are selected to operate with an outlet 196 located 240 feet from the distribution unit 60. Such an outlet is constructed with built-in baluns 34, 36. For an outlet 198 located closer to the distribution unit 38, the baluns 34, 36 are supplemented by cable simulators 200, 202, respectively, on the unbalanced sides of the baluns, which add attenuation equivalent to the missing length of twisted pair wire cable 32. Thus, for the distant outlet 196, two hundred forty feet of twisted wire pair cable is utilized. For closer outlet 198, one hundred twenty feet of twisted pair wire cable is utilized and the cable simulators 200, 202 add an amount of attenuation equivalent to the missing one hundred twenty feet of twisted pair wire cable. Thus, all signals entering and leaving a distribution unit 38 are within a specified range of levels, irrespective of the distance to the outlet. However, as noted previously, where greater distances are to be gained by the use of coaxial cable or fiber optic cable.

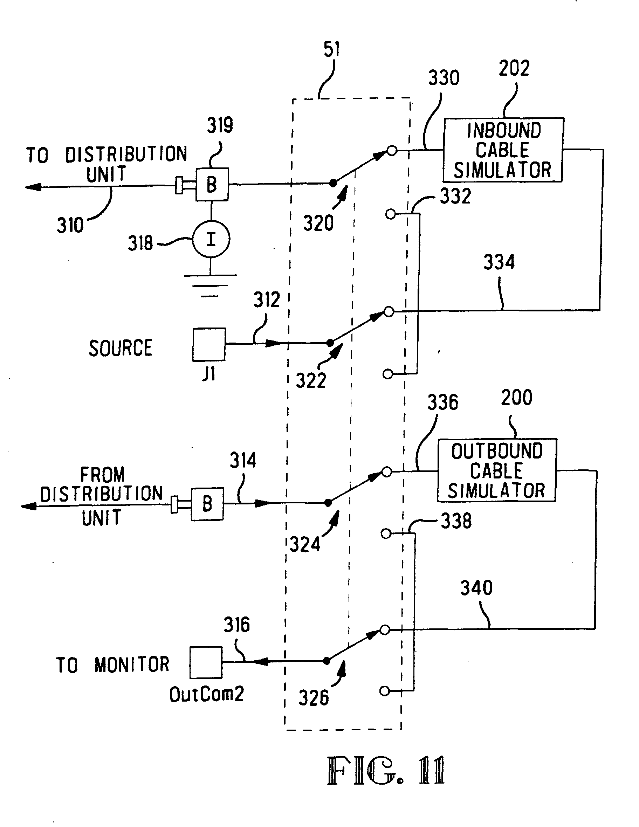

Figure 11 shows a block diagram of an enabling circuit and an example of a cable simulator switchable circuit 131, 137 which operates between a distribution unit 60 as shown in Fig. 10 and a source 24 of video or other baseband signals. This circuit may be housed for example in the breakout box 27 (FIG. 1) or in a wall outlet box 26. A source signal, for example a video signal from a VCR 24 or from a cable television channel, is connected to input line 312 of the enabling circuit. This signal is ultimately supplied to line 310 of the enabling circuit where a positive polarity DC signal is added to the base band video source signal. The DC signal is supplied by the current supply 318 which is connected to the output balun 319.

This circuit is switchable so that it can simulate various lengths of cable in order to achieve a desired attenuation at the outlets 198 (FIG. 10) of the circuit. When the switch parts 320, 322, 324 and 326 are in the position shown in Figure 11, the base band input signal on line 312 passes through an input 334 to an inbound cable simulator 202, which consists of an impedance to simulate a desired length of cable for example 120 feet or 1/2 of the maximum distance which in this example is 240 ft. The output of the inbound cable simulator 202 is then passed through line 330 and switch part 320 to the output balun 319, where it is combined with the enabling DC signal from the current source 318. This signal is then supplied as an enabled input signal, which will bias a diode switch 63 in the distribution unit 38 shown in Figure 2. Similarly, the output from the distribution unit connected to line 314 of the enabling circuit is switched to achieve a desired attenuation by simulating an outbound cable equivalent in length to the inbound cable simulated above. When switch parts 324 and 326 are in the position shown in Figure 11, the outbound signal from the distribution unit passes to the input 336 of an outbound cable simulator 200 which is an impedance designed to simulate a given length of cable in order to achieve a desired level of attenuation. The output 340 of the outbound cable simulator 200 is then passed through the switch part 326 and to the output port 316 to be ultimately supplied to a monitor or some other display device. As the length of cable 32 is increased and the outlet box 196 is further from the distribution unit, both the inbound and outbound cable simulators may be switched out of the circuit by actuating the switch parts 320, 322, 324, 326.

The DC current source 18 is used to bias a PIN diode switch 63-1 through 63-8 shown in Figures 2 and 3. The switch 63 will be turned on when an enabled input as described above is applied. The switch 63 will be off when the respective cable 32 is not being used as an input. This PIN diode switch 63 will allow only those inputs to the distribution unit which are currently in use to be active, thus reducing the total number of active inputs, and cables in the system therefore reducing the near end cross talk in the modulated frequency band. Since there are only a limited number of channels, there can only be a total possible number of active inputs equal to or less than the number of channels thus greatly reducing the possibility of near and cross talk due to multiple system inputs having lengths of wire which can cross talk with each other.

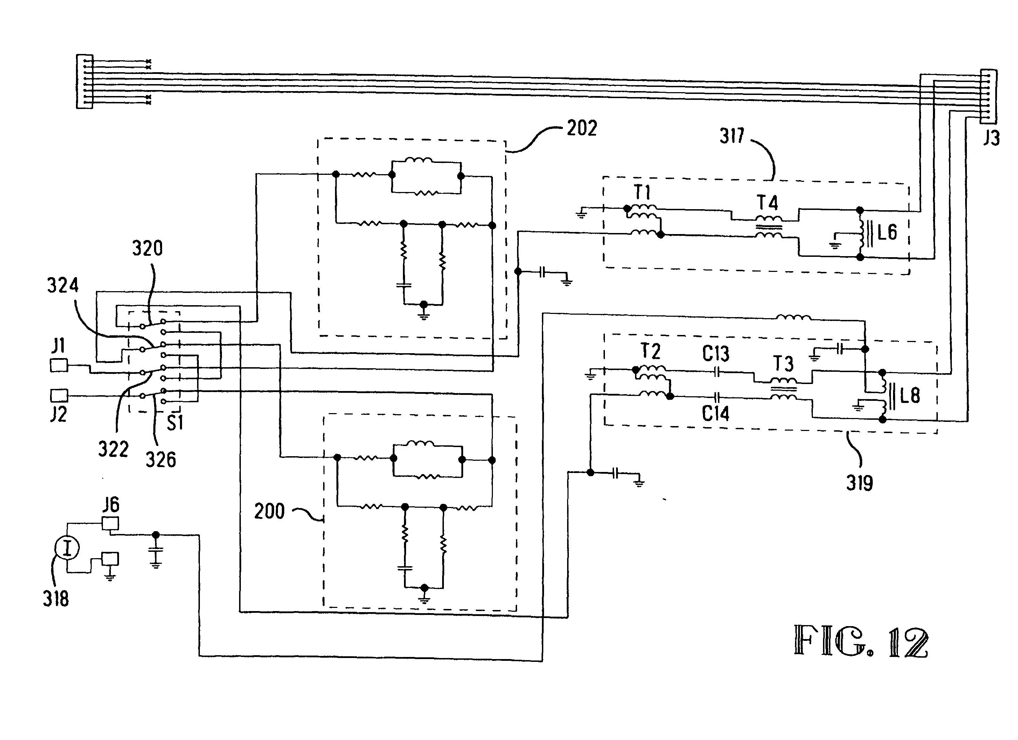

Operation of the cable simulator and enabling circuits of the present invention will now be described in greater detail. Referring to Figures 11 and 12, an example of the enabling circuit and cable simulator circuit of the present invention is shown. When the switch S1 is in the position shown, the cable simulators 200,202 are switched into the circuit. An inbound signal from a source such as a VCR is supplied to the inbound port J1 and then passes through switch parts 322 and is attenuated through the inbound cable simulator 202. The output of the inbound cable simulator 202 is applied to switch part 320 and then passes through a balun 319 consisting of T2, C13, C14, T3, and L8 where it is mixed with a DC current signal at L8 to create an enabled signal. The DC current signal is supplied from a source 318 at J6. This enabled signal then passes to a connector J3 and is the inbound signal to the wideband signal distribution unit. The outbound wideband distribution signal from the distribution unit enters the enabling cable simulator circuit through the same connector J3. The outbound modulated signal then passes through a balun 317 for impedance matching which consists of L6, T4 and T1 and then through switch part 324. From switch part 324, the signal passes through the outbound cable simulator 200 to simulate an equivalent length of cable as the inbound cable simulator 202 described above. This signal is then passed through switch part 320 to the outbound port J2. The outbound signal coming from this port J2 can be displayed on a monitor. Actuation of the switch S1 causes both the inbound and outbound cable simulators to be switched out of the circuit allowing both the inbound and outbound signals to pass through this circuit without added attenuation.

An advantage of this circuit is that the number of inputs can be greatly increased since each input is turned off when not in use thus avoiding such inputs from contributing to near end cross talk.

Another advantage of this circuit is that outlets at various lengths from the distribution will receive similarly attenuated signals resulting in a more uniform picture quality or signal level at each receiving location. Accordingly, there has been disclosed an improved wideband signal distribution system which is capable of utilizing twisted pair wire cable as the primary distribution media. While an illustrative embodiment of the present invention has been disclosed herein, it is understood that various modifications and adaptations to the disclosed embodiment will be apparent to those of ordinary skill in the art and it is intended that this invention be limited only by the scope of the appended claims. Thus, while the distribution of video signals has been specifically described, it is understood that the described system may also be used for distributing wideband signals generally.

## Claims

1. A system for distributing wideband signals modulated onto RF carriers
within a specified frequency band among a plurality of outlets, each outlet (120, 118) being connected to a source or destination of the wideband signals, the system comprising a
distribution unit (**38, 52, 54, 60**) including:
a plurality of input ports (**62**);
a plurality of output ports (**64**);
a transmission path ( **95**);
combiner means (**72**) for applying signals appearing at said plurality of input ports (**62**) to said transmission path (**95**); and
splitter means (**84**) for applying signals appearing on said transmission path (**95**) to all of said plurality of output ports (**64**); the system **characterized by**;
a plurality of cables (**66, 68, 121, 123**) selected from the class consisting of fiber optic cable, coaxial cable, and twisted pair wire cable, and extending between a respective one of said distribution unit ports (**62, 64**) and a respective one of said plurality of outlets (**118, 120**); and further **characterised in that** the distribution unit (**38, 52, 54, 60**) includes
a signal inlet (**102**);
a signal outlet (**104**);
switch means (**90, 92, 94**) operable to either a first state or a second state, said switch means (**90, 92, 94**) when in its first state being effective to couple said transmission path (**95**) to said combiner means (**72**) and to said splitter means (**84**), and said switch means when in its second state being effective to couple said combiner means (**72**) to said signal outlet (**104**) instead of to said transmission path (**95**) and to couple said splitter means (**84**) to said signal inlet (**102**) instead of to said transmission path (**95**); and
a plurality of impedance matching devices (**70, 88**), each of said devices terminating a respective end of a respective one of said cables,
the system being still further **characterised in that** it includes first and second said distribution units (**38, 52, 54, 60**) with one of the output ports (**64**) of the first distribution unit (**38, 52, 54, 60**) being connected to the signal inlet (**102**) of the second distribution unit and one of the input ports (**62**) of the first distribution unit being connected to the signal outlet (**104**) of the second distribution unit, the switch means (**90, 92, 95**) of the first distribution unit being in its first state, and the switch means (**90, 92, 95**) of the second distribution unit being in its second state.

2. The system according to claim **1** wherein each of said distribution units further idcludes:
oscillator means (**98**) for providing an oscillating pilot signal at a fixed frequency outside the specified frequency band of the RF carriers;
first controllable gain means interposed between said switch means (**90, 92, 95**) and said signal outlet (**104**); and
second controllable gain means interposed between said signal inlet (**102**) and said switch means (**90, 92, 95**);
wherein said switch means when in its first state is further effective to couple said oscillator means (**98**) to said transmission path (**95**); and
wherein each of said distribution units (**30, 52, 54, 60**) further includes gain control means (**112**) responsive to the level of said pilot signal for controlling the gain of said first and second gain means.

3. The system according to claim **2** wherein said switch means (**90, 92, 94**) in each of said distribution units defaults to its first state and is responsive to the appearance of said pilot signal at said signal inlet (**102**) for changing to its second state.

4. The system according to claim **2** or **3** wherein said first controllable gain means includes a first variable attenuator (**116**), said second controllable gain means includes a second variable attenuator (**106**) and an amplifier (**108**) having a fixed gain connected to the output of the second variable attenuatort (**106**), and said gain control means is coupled to the output of said amplifier (**108**) and to said first and second variable attenuators (**116, 106**).

5. The system according to claim **4** wherein said first and second variable attenuators (**116, 106**) are substantially identical and each of said distribution units further includes an amplifier (**108**) having a gain equal to the fixed gain of the amplifier (**108**) of said second controllable gain means and connected between said combiner means (**72**) and said switch means (**90, 92, 94**).

6. The system according to any of claims **2** to **5**, wherein said distribution unit (**38, 52, 54, 60**) further includes directional coupling means (**100**) for coupling said oscillator means (**98**) to said transmission path (**95**) and wherein said switch means (**90, 92, 94**) is effective to remove power from said oscillator means (**98**) when said switch means (**90, 92, 94**) is in its second state.

7. The system according to any preceding claim, wherein said distribution unit (**38, 52, 54**) further includes means for indicating the state of said switch means (**90, 92, 94**).

8. The system according to any preceding claim wherein said distribution unit (**38, 52, 54, 60**) further includes signal equalizing means (96) interposed in said transmission path (**95**).

9. The system according to any preceding claim wherein there is an equal number of said input and output ports (**62, 64**) in said distribution unit (**38, 52, 54, 60**).

10. The system according to any preceding claim wherein said cables (**66, 68, 121, 123**) include twisted pair wire cables and said impedance matching devices include baluns, said system further comprising a first group of baluns (**70**) arranged as part of said distribution unit and located between said combiner means (**72**) and said plurality of input ports (**62**);
a second group of baluns (**88**) arranged as part of said distribution unit and located between said splitter means (**84**) and said plurality of output ports (**64**); and
a third group of baluns (**34, 36**) located at the ends of said cables remote from said distribution unit.

11. The system according to claim **10** wherein said plurality of twisted pair cables are all of the same type and are either within a first length range or a second length range equal to the maximum length of said first length range plus a third length range, the system further including cable simulator means (**200, 202**) connected to those baluns of the third group of baluns (**34, 36**) which are connected to the cables of the second length range for simulating a length of cable equal to the maximum length of said third length range.

12. The system according to any of claims **1** to **9** wherein said cables include fiber optic cables and said impedance matching devices include an optoelectric transceiver.

13. The system according to any of claims **1** to **9** wherein said cables include coaxial cables and said impedance matching devices include a transformer (**126**).

14. The system according to any preceding claim including
a signal enabling circuit provided at at least one of said plurality of outlets (**118, 120**), said signal enabling circuit consisting of a DC power source (**318**) and a combiner,
whereby a DC signal is combined with an input signal to the outlet.

15. The system according to any preceding claim including a cable simulator circuit provided at at least one of said plurality of outlets (**118, 120**), said cable simulator circuit consisting of an inbound cable simulator (**202**), an outbound cable simulator (**200**), and a switch (**320, 322, 328, 326**), whereby the inbound and outbound cable simulator (**202, 200**) may be switched into a circuit between a source and one of said cables extending between one of said respective distribution unit ports and one of said respective plurality of outlets.

16. A distribution unit (**38, 52, 54, 60**) for use in a wideband signal distribution system, where the system includes a plurality of outlets (**118, 120**) each outlet being connected to a source or a destination of wideband signals, and a plurality of cables (**66, 68**) extending between the outlets (**118, 120**) and the distribution unit for carrying wideband signals modulated onto **RF** carriers within a specified frequency band between the outlets, the distribution unit (**38, 52, 54, 60**) comprising
a plurality of input ports (**62**) each adapted to be connected to a respective one of said cables;
a plurality of output ports (**64**);
a combiner (**72**) having a plurality of input terminals and having an output terminal to which is applied a combind signal which is an additive combination of all sgnals appearing at said input ports (**62**);
a splitter (**84**) having an input terminal and a plurality of output terminals to all of which is applied a signal appearing at the splitter input terminal;
a transmission path (**95**) coupled between said combiner output terminal and said splitter input terminal;
**characterised by**;
a first plurality of impedance matching devices (**70**) each having its balanced end connected to a respective one of said input ports (**62**);
a second plurality of impedance matching devices (**88**) each having its unbalanced end connected to a respective one of said splitter output terminals;
a signal inlet (**102**) adapted to be coupled to a cable extending to an output port of another said distribution unit (**38, 82, 54, 60**) of identical construction;
a signal outlet (**104**) adapted to be coupled to a cable extending to an input port (**62**) of said another distribution unit; and
switch means (**90, 92, 94**) operable to either a first state or a second state, said switch means (**90, 92, 94**) being coupled to said transmission path (**95**), said combiner output terminal, said splitter input terminal, said signal inlet (**102**) and said signal outlet (**104**), said switch means (**90, 92, 94**) when in its first state being effective to couple said transmission path (**95**) to said combiner output terminal (**72**) and said splitter input terminal, and said switch means (**90, 92, 94**) when in its second state being effective to couple said combiner output terminal to said signal outlet (**104**) and to couple said signal inlet (**102**) to said splitter input terminal;
and further **characterised in that** each combined input terminal is connected to the unbalanced end of a respective one of said first plurality of impedance matching devices (**70**);
each output port (**64**) connected to the balanced end of a respective one of said second plurality of impedance matching devices (**88**) and each is adapted to be connected to a respective one of said cables;

17. The distribution unit according to claim **16** including an oscillator (**98**) providing a fixed frequency pilot signal outside the specified frequency band of the RF carriers; and switch control means (**114**) responsive to the presence of said pilot signal at said signal inlet (**102**) for controlling said switch means (**90, 92, 94**) to assume its second state;
wherein the default state of said switch means (**90, 92, 94**) is its first state and wherein said switch means (**90, 92, 94**) when in its first state is further effective to couple said oscillator fixed frequency pilot signal to said transmission path (**95**).

18. The distribution unit according to claim **17** including
first controllable gain means coupled between said signal outlet (**104**) and said switch means (**90, 92, 94**);
second controllable gain means coupled between said signal inlet (**102**) and said switch means; and gain control means (**112**) having an input coupled between said second controllable gain means and said switch means and
responsive to the level of said pilot signal for controlling the gain of both said first and second gain means (**106, 116**).

19. The distribution unit according to claim **17** or **18**, including a directional coupler (**116**) having an input interposed between said second gain means and said switch means (**90, 92, 94**) and an output coupled to the input of said gain control means; and
wherein said gain control means (**112**) includes a bandpass filter (**162**) tuned to pass said pilot signal, said bandpass filter (**162**) being serially connected between said gain control means input and the remainder of said gain control means.

20. The distribution unit according to claim **18** or **19** wherein each of said first and second gain means (**132, 136**) includes a variable attenuator (**106, 116**) having a p-i-n diode with its cathode connected to the respective signal inlet or outlet (**102, 104**) and its anode connected to the switch means (**90, 92, 94**), and a source of bias current connected to the anode of the p-i-n diode; and
the gain control means (**112**) has an output connected to the cathode of the p-i-n diode to vary the bias current therethrough.

21. The distribution unit according to claim **19** or **21** wherein said switch control means (**114**) is coupled to said bandpass filter (**162**) remote from said gain control means input.

22. The distribution unit according to any of claims **16** to **21** wherein the distribution unit further includes a signal equalizing means (**96**) interposed in said transmission path (**95**).

23. The distribution unit according to any of claims **16** to **22** including means for indicating the state of said switch means.

24. The distribution unit according to any of claims **16** to **23** including
a first light emitting diode (**188, 190**);
a second light emitting diode (**188, 190**);
a first voltage source coupled to the anodes of the light emitting diodes;
a second voltage source at a level less than the level of the first voltage source coupled to the cathodes of the light emitting diodes;
first controllable switching means (**192, 194**) connected in series with said first light emitting diode (**188, 190**) and having a control input; second controllable switching means (**192, 194**) connected in series with said second light emitting diode (**192,194**) and having a control input; and
means for coupling said switch control means (**90, 92, 94**) to the control inputs of said first and second controllable switching means (**192, 194**); wherein said first and second controllable switching means (**192, 194**) respond to different level signals at their control inputs to provide current paths for their respective light emitting diodes (**190, 188**) and said switch control means (**90, 92, 94**) provides said different level signals corresponding to respective states of said switch means (**90, 92, 94**).

## Patentansprüche

1. System zur Verteilung von Breitbandsignalen, die auf HF-Träger in einem vorgegebenen Frequenzband moduliert sind, auf eine Vielzahl von Auslässen, wobei jeder Auslaß (120, 118) mit einer Quelle oder einem Ziel der Breitbandsignale verbunden ist, wobei das System umfaßt:
eine Verteilungseinheit (38, 52, 54, 60), die aufweist:
eine Vielzahl von Eingangsanschlüssen (62);
eine Vielzahl von Ausgangsanschlüssen (64);
einen Übertragungsweg (95);
eine Kombinatoreinrichtung (72) zum Anlegen von Signalen, die in der Vielzahl von Eingangsanschlüssen (62) auftreten, an den Übertragungsweg (95); und
eine Verteilereinrichtung (84) zum Anlegen von Signalen, die auf dem . Übertragungsweg (95) auftreten, an alle aus der Vielzahl von Ausgangsanschlüssen (64);
wobei das System **gekennzeichnet ist durch**:
eine Vielzahl von Kabeln (66, 68, 121, 123), die aus einer Klasse gewählt sind, die aus Glasfaserkabel, Koaxialkabel und paarverseiltem Drahtkabel besteht, und die sich zwischen einem entsprechenden der Verteilungseinheitsanschlüsse (62, 64) und einem entsprechenden aus der Vielzahl von Auslässen (118, 120) erstrecken; und ferner **dadurch** gekennzeichnet, daß die Verteilungseinheit (38, 52, 54, 60) aufweist:
einen Signaleinlaß (102);
einen Signalauslaß (104);
eine Schaltereinrichtung (90, 92, 94), die entweder in einem ersten Zustand oder in einem zweiten Zustand betriebsfähig ist, wobei die Schaltereinrichtung (90, 92, 94), wenn sie in ihrem ersten Zustand ist, die Wirkung hat, den Übertragungsweg (95) mit der Kombinatoreinrichtung (72) und der Verteilereinrichtung (84) zu koppeln, und die Schaltereinrichtung, wenn sie in ihrem zweiten Zustand ist, die Wirkung hat, die Kombinatoreinrichtung (72) mit dem Signalauslaß (104) anstatt mit dem Übertragungsweg (95) zu koppeln und die Verteilereinrichtung (84) mit dem Signaleinlaß (101) anstatt mit dem Übertragungsweg (95) zu koppeln; und
eine Vielzahl von Impedanzanpassungsvorrichtungen (70, 88), wobei jede der Vorrichtungen ein entsprechendes Ende eines entsprechenden der Kabel abschließt;
wobei das System ferner noch **dadurch** gekennzeichnet ist, daß es die erste und die zweite Verteilungseinheit (38, 52, 54, 60) aufweist, wobei einer der Ausgangsanschlüsse (64) der ersten Verteilungseinheit (38, 52, 54, 60) mit dem Signaleinlaß (102) der zweiten Verteilungseinheit verbunden ist und einer der Eingangsanschlüsse (62) der ersten Verteilungseinheit mit dem Signalauslaß (104) der zweiten Verteilungseinheit verbunden ist, wobei die Schaltereinrichtung (90, 92, 95) der ersten Verteilungseinheit in ihrem ersten Zustand ist und die Schaltereinrichtung (90, 92, 95) der zweiten Verteilungseinheit in ihrem zweiten Zustand ist.

2. System nach Anspruch 1, wobei jede der Verteilungseinheiten ferner aufweist:
eine Oszillatoreinrichtung (98) zum Liefern eines oszillierendes Pilotsignals mit einer festen Frequenz außerhalb des vorgegebenen Frequenzbandes der HF-Träger;
eine erste steuerbare Verstärkungseinrichtung, die zwischen die Schaltereinrichtung (90, 92, 95) und den Signalauslaß (104) geschaltet ist; und
eine zweite steuerbare Verstärkungseinrichtung, die zwischen den Signaleinlaß (102) und die Schaltereinrichtung (90, 92, 95) geschaltet ist;
wobei die Schaltereinrichtung, wenn sie in ihrem ersten Zustand ist, ferner die Wirkung hat, die Oszillatoreinrichtung (98) mit dem Übertragungsweg (95) zu koppeln; und
wobei jede der Verteilungseinheiten (30, 52, 54, 60) ferner eine Verstärkungsregelungseinrichtung (112) aufweist, die auf den Pegel des Pilotsignals anspricht, zum Steuern der Verstärkung der ersten und der zweiten Verstärkungseinrichtung.

3. System nach Anspruch 2, wobei die Schaltereinrichtung (90, 92, 94) in jeder der Verteilungseinheiten in ihren ersten Zustand zurückgeht und auf das Auftreten des Pilotsignals an dem Signaleinlaß (102) anspricht, um in ihren zweiten Zustand zu wechseln.

4. System nach Anspruch 2 oder 3, wobei die erste steuerbare Verstärkungseinrichtung ein erstes regelbares Dämpfungsglied (116) aufweist, die zweite steuerbare Verstärkungseinrichtung ein zweites regelbares Dämpfungsglied (106) und einen Verstärker (108) mit einer festen Verstärkung aufweist, der mit dem Ausgang des zweiten regelbaren Dämpfungsglieds (106) verbunden ist, und wobei die Verstärkungsregelungseinrichtung mit dem Ausgang des Verstärkers (108) und dem ersten und dem zweiten regelbaren Dämpfungsglied (116, 106) gekoppelt ist.

5. System nach Anspruch 4, wobei das erste und das zweite regelbare Dämpfungsglied (116, 106) im wesentlichen identisch sind und jede der Verteilungseinheiten ferner einen Verstärker (108) aufweist, der eine Verstärkung aufweist, die der festen Verstärkung des Verstärkers (108) der zweiten steuerbaren Verstärkungseinrichtung entspricht, und der zwischen die Kombinatoreinrichtung (72) und die Schaltereinrichtung (90, 92, 94) geschaltet ist.

6. System nach einem der Ansprüche 2 bis 5, wobei die Verteilungseinheit (38, 52, 54, 60) ferner eine gerichtete Koppeleinrichtung (100) aufweist, zum Koppeln der Oszillatoreinrichtung (98) mit dem Übertragungsweg (95), und wobei die Schaltereinrichtung (90, 92, 94) die Wirkung hat, der Oszillatoreinrichtung (98) Strom zu entziehen, wenn die Schaltereinrichtung (90, 92, 94) in ihrem zweiten Zustand ist.

7. System nach einem der vorhergehenden Ansprüche, wobei die Verteilungseinheit (38, 52, 54) ferner eine Einrichtung zum Anzeigen des Zustands der Schaltereinrichtung (90, 92, 94) aufweist.

8. System nach einem der vorhergehenden Ansprüche, wobei die Verteilungseinheit (38, 52, 54, 60) ferner eine Signalentzerrungseinrichtung (96) aufweist, die in dem Übertragungsweg (95) angeordnet ist.

9. System nach einem der vorhergehenden Ansprüche, wobei eine gleiche Anzahl der Eingangs- und des Ausgangsanschlüsse (62, 64) in der Verteilungseinheit (38, 52, 54, 60) vorhanden ist.

10. System nach einem der vorhergehenden Ansprüche, wobei die Kabel (66, 68, 121, 123) paarverseilte Drahtkabel aufweisen und die Impedanzanpassungsvorrichtungen Symmetrieglieder aufweisen, wobei das System ferner umfaßt: eine erste Gruppe von Symmetriegliedern (70), die als Teil der Verteilungseinheit angeordnet sind und sich zwischen der Kombinatoreinrichtung (72) und der Vielzahl von Eingangsanschlüssen (62) befinden;
eine zweite Gruppe von Symmetriegliedern (88), die als Teil der Verteilungseinheit angeordnet sind und sich zwischen der Verteilereinrichtung (84) und der Vielzahl von Ausgangsanschlüssen (64) befinden; und
eine dritte Gruppe von Symmetriegliedern (34, 36), die an den Enden der Kabel entfernt von der Verteilungseinheit angeordnet sind.

11. System nach Anspruch 10, wobei die Vielzahl der paarverseilten Drahtkabel alle vom gleichen Typ sind und entweder in einem ersten Längenbereich oder in einem zweiten Längenbereich liegen, der der maximalen Länge des ersten Längenbereichs plus einem dritten Längenbereich entspricht, wobei das System ferner eine Kabelsimulatoreinrichtung (200, 202) aufweist, die mit denjenigen Symmetriegliedern der dritten Gruppe von Symmetriegliedern (34, 36) verbunden ist, die mit den Kabeln des zweiten Längenbereichs verbunden sind, zum Simulieren einer Kabellänge, die der maximalen Länge des dritten Längenbereichs entspricht.

12. System nach einem der Ansprüche 1 bis 9, wobei die Kabel faseroptische Kabel aufweisen und die Impedanzanpassungsvorrichtungen einen optoelektrischen Senderempfänger aufweisen.

13. System nach einem der Ansprüche 1 bis 9, wobei die Kabel Koaxialkabel aufweisen und die Impedanzanpassungsvorrichtungen einen Transformator (126) aufweisen.

14. System nach einem der vorhergehenden Ansprüche, mit
einer Signalfreigabeschaltung, die mindestens an einem aus der Vielzahl von Auslässen (118, 120) vorgesehen ist, wobei die Signalfreigabeschaltung aus einer Gleichstromquelle (318) und einem Kombinator besteht,
wodurch ein Gleichstromsignal mit einem Eingangssignal zum Auslaß kombiniert wird.

15. System nach einem der vorhergehenden Ansprüche, mit einer Kabelsimulatorschaltung, die mindestens an einem aus der Vielzahl von Auslässen (118, 120) vorgesehen ist, wobei die Kabelsimulatorschaltung aus einem hineinführenden Kabelsimulator (202), einem hinausführenden Kabelsimulator (200) und einem Schalter (320, 322, 328, 326) besteht, wodurch der hinein- und der hinausführende Kabelsimulator (202, 200) in eine Schaltung zwischen einer Quelle und einem der Kabel geschaltet werden kann, das sich zwischen einem der entsprechenden Verteilungseinheitsanschlüsse und einem aus der entsprechenden Vielzahl von Auslässen erstreckt.

16. Verteilungseinheit (38, 52, 54, 60) zur Verwendung in einem Breitbandsignalverteilungssystem, wobei das System aufweist: eine Vielzahl von Auslässen (118, 120), wobei jeder Auslaß mit einer Quelle oder einem Ziel von Breitbandsignalen verbunden ist, und eine Vielzahl von Kabeln (66, 68), die sich zwischen den Auslässen (118, 120) und der Verteilungseinheit erstrecken, zum Transportieren von Breitbandsignalen, die auf HF-Trägern in einem vorgegebenen Frequenzband moduliert sind, zwischen den Auslässen, wobei die Verteilungseinheit (38, 52, 54, 60) umfaßt:
eine Vielzahl von Eingangsanschlüssen (62), die jeweils geeignet sind, mit einem entsprechenden der Kabel verbunden zu werden;
eine Vielzahl von Ausgangsanschlüssen (64);
einen Kombinator (72) mit einer Vielzahl von Eingangsanschlüssen und mit einem Ausgangsanschluß, an den ein kombiniertes Signal angelegt wird, das eine Additionskombination aller Signale ist, die an den Eingangsanschlüssen (62) auftreten;
einen Verteiler (84) mit einem Eingangsanschluß und einer Vielzahl von Ausgangsanschlüssen, an die alle ein Signal angelegt wird, das am Verteilereingangsanschluß erscheint;
einen Übertragungsweg (95), der zwischen den Kombinatorausgangsanschluß und den Verteilereingangsanschluß gekoppelt ist;
**gekennzeichnet durch**:
eine erste Vielzahl von Impedanzanpassungsvorrichtungen (70), deren symmetrisches Ende jeweils mit einem entsprechenden der Eingangsanschlüsse (62) verbunden ist;
eine zweite Vielzahl von Impedanzanpassungsvorrichtungen (88), deren unsymmetrisches Ende jeweils mit einem entsprechenden der Verteilerausgangsanschlüsse verbunden ist;
einen Signaleinlaß (102), der geeignet ist, mit einem Kabel gekoppelt zu werden, das sich zu einem Ausgangsanschluß der anderen Verteilungseinheit (38, 82, 54, 60) mit identischem Aufbau erstreckt;
einen Signalauslaß (104), der geeignet ist, mit einem Kabel gekoppelt zu werden, das sich zu einem Eingangsanschluß (62) der anderen Verteilungseinheit erstreckt; und
eine Schaltereinrichtung (90, 92, 94), die entweder in ihrem ersten Zustand oder in ihrem zweiten Zustand betriebsfähig ist, wobei die Schaltereinrichtung (90, 92, 94) mit dem Übertragungsweg (95), dem Kombinatorausgangsanschluß, dem Verteilereingangsanschluß, dem Signaleinlaß (102) und dem Signalausmaß (104) gekoppelt ist, wobei die Schaltereinrichtung (90, 92, 94), wenn sie in ihrem ersten Zustand ist, die Wirkung hat, den Übertragungsweg (95) mit dem Kombinatorausgangsanschluß (72) und dem Verteilereingangsanschluß zu koppeln, und die Schaltereinrichtung (90, 92, 94), wenn sie in ihrem zweiten Zustand ist, die Wirkung hat, den Kombinatorausgangsanschluß mit dem Signalausmaß (104) zu koppeln und den Signaleinlaß (102) mit dem Verteilereingangsanschluß zu koppeln;
und ferner **dadurch** gekennzeichnet, daß jeder kombinierte Eingangsanschluß mit dem unsymmetrischen Ende eines entsprechenden aus der Vielzahl von Impedanzanpassungsvorrichtungen (70) verbunden ist;
jeder Ausgangsanschluß (64), der mit dem symmetrischen Ende eines entsprechenden aus der zweiten Vielzahl von Impedanzanpassungsvorrichtungen (88) verbunden ist und jeweils geeignet ist, mit einem entsprechenden der Kabel verbunden zu werden.

17. Verteilungseinheit nach Anspruch 16 mit einem Oszillator (98), der ein Festfrequenz-Pilotsignal außerhalb des vorgegebenen Frequenzbandes der HF-Träger bereitstellt; und einer Schaltersteuereinrichtung (114), die auf das Vorhandensein des Pilotsignals an dem Signaleinlaß (102) anspricht, zum Steuern der Schaltereinrichtung (90, 92, 94), so daß diese ihren zweiten Zustand annimmt;
wobei der Standardvorgabezustand der Schaltereinrichtung (90, 92, 94) ihr erster Zustand ist und wobei die Schaltereinrichtung (90, 92, 94), wenn sie in ihrem ersten Zustand ist, ferner die Wirkung hat, das Festfrequenz-Pilotsignal des Oszillators mit dem Übertragungsweg (95) zu koppeln.

18. Verteilungseinheit nach Anspruch 17 mit
einer ersten steuerbaren Verstärkungseinrichtung, die zwischen den Signalauslaß (104) und die Schaltereinrichtung (90, 92, 94) gekoppelt ist;
einer zweiten steuerbaren Verstärkungseinrichtung, die zwischen den Signaleinlaß (102) und die Schaltereinrichtung gekoppelt ist; und
einer Verstärkungsregelungseinrichtung (112), die einen Eingang aufweist, der zwischen die zweite steuerbare Verstärkungseinrichtung und die Schaltereinrichtung gekoppelt ist, und die auf den Pegel des Pilotsignals anspricht, zum Steuern der Verstärkung sowohl der ersten als auch der zweiten Verstärkungseinrichtung (106, 116).

19. Verteilungseinheit nach Anspruch 17 oder 18, mit einem gerichteten Koppler (116) mit einem Eingang, der zwischen der zweiten Verstärkungseinrichtung und der Schaltereinrichtung (90, 92, 94) angeordnet ist, und mit einem Ausgang, der mit dem Eingang der Verstärkungsregelungseinrichtung gekoppelt ist; und
wobei die Verstärkungsregelungseinrichtung (112) ein Bandpaßfilter (162) aufweist, das so abgestimmt ist, daß das Pilotsignal durchgelassen wird, wobei das Bandpaßfilter (162) zwischen den Verstärkungsregelungseinrichtungseingang und den Rest der Verstärkungsregelungseinrichtung in Reihe geschaltet ist.

20. Verteilungseinheit nach Anspruch 18 oder 19, wobei sowohl die erste als auch die zweite Verstärkungseinrichtung (132, 136) ein regelbares Dämpfungsglied (106, 116) aufweist, wobei die Kathode seiner PIN-Diode mite dem entsprechenden Signaleinlaß oder -auslaß (102, 104) verbunden ist und ihre Anode mit der Schaltereinrichtung (90, 92, 94) verbunden ist, und eine Quelle eines Vorspannungsstroms mit der Anode der PIN-Diode verbunden ist; und
die Verstärkungsregelungseinrichtung (112) einen Ausgang hat, der mit der Kathode der PIN-Diode verbunden ist, um den Vorspannungsstrom in dieser zu variieren.

21. Verteilungseinheit nach Anspruch 19 oder 21, wobei die Schaltersteuereinrichtung (114) mit dem Bandpaßfilter (162) entfernt von dem Verstärkungsregelungseinrichtungseingang gekoppelt ist.

22. Verteilungseinheit nach einem der Ansprüche 16 bis 21, wobei die Verteilungseinheit ferner eine Signalentzerrungseinrichtung (96) aufweist, die in dem Übertragungsweg (95) angeordnet ist.

23. Verteilungseinheit nach einem der Ansprüche 16 bis 22 mit einer Einrichtung zum Anzeigen des Zustands der Schaltereinrichtung.

24. Verteilungseinheit nach einem der Ansprüche 16 bis 23 mit
einer ersten lichtemittierenden Diode (188, 190);
einer zweiten lichtemittierenden Diode (188, 190);
einer ersten Spannungsquelle, die mit den Anoden der lichtemittierenden Dioden verbunden ist;
einer zweiten Spannungsquelle mit einem Pegel, der kleiner ist als der Pegel der ersten Spannungsquelle, die mit den Kathoden der lichtemittierenden Dioden gekoppelt ist;
einer ersten steuerbaren Schalteinrichtung (192, 194), die mit der ersten lichtemittierenden Diode (188, 190) in Reihe geschaltet ist und einen Steuereingang aufweist;
einer zweiten steuerbaren Schalteinrichtung (192, 194), die mit der zweiten lichtemittierenden Diode (192, 194) in Reihe geschaltet ist und einen Steuereingang aufweist; und
einer Einrichtung zum Koppeln der Schaltersteuereinrichtung (90, 92, 94) mit den Steuereingängen der ersten und der zweiten steuerbaren Schalteinrichtung (192, 194); wobei die erste und die zweite steuerbare Schalteinrichtung (192, 194) auf Signale mit verschiedenen Pegeln an ihren Steuereingängen antworten, um Stromwege für ihre entsprechende lichtemittierende Dioden (190, 188) bereitzustellen, und die Schaltersteuereinrichtung (90, 92, 94) die Signale mit verschiedenen Pegeln entsprechend den jeweiligen Zuständen der Schaltereinrichtung (90, 92, 94) bereitstellt.

## Revendications

1. Système pour distribuer des signaux large bande qui sont modulés sur des porteuses RF dans une bande de fréquence spécifiée entre une pluralité de sorties, chaque sortie (120, 118) étant connectée à une source ou à une destination des signaux large bande, le système comprenant
une unité de distribution (38, 52, 54, 60) incluant:
une pluralité de ports d'entrée (62);
une pluralité de ports de sortie (64);
une voie de transmission (95);
un moyen combineur (72) pour appliquer des signaux qui apparaissent au niveau de ladite pluralité de ports d'entrée (62) sur ladite voie de transmission (95); et
un moyen de séparateur (84) pour appliquer des signaux qui apparaissent sur ladite voie de transmission (95) sur tous les ports de ladite pluralité de ports de sortie (64),
le système étant **caractérisé par**:
une pluralité de câbles (66, 68, 121, 123) sélectionnés parmi la classe constituée par un câble à fibre optique, un câble coaxial et un câble filaire à paire torsadée, et s'étendant entre l'un respectif desdits ports d'unité de distribution (62, 64) et l'une respective de ladite pluralité de sorties (118, 120); et **caractérisé en outre en ce que** l'unité de distribution (38, 52, 54, 60) inclut:
une entrée de signal (102);
une sortie de signal (104);
un moyen de commutateur (90, 92, 94) qui peut fonctionner dans soit un premier état, soit un second état, ledit moyen de commutateur (90, 92, 94), lorsqu'il est dans son premier état, étant efficace pour coupler ladite voie de transmission (95) audit moyen de combineur (72) et audit moyen de séparateur (84) et ledit moyen de commutateur, lorsqu'il est dans son second état, étant efficace pour coupler ledit moyen de combineur (72) sur ladite sortie de signal (104) en lieu et place de ladite voie de transmission (95) et pour coupler ledit moyen de séparateur (84) sur ladite entrée de signal (102) en lieu et place de ladite voie de transmission (95); et
une pluralité de dispositifs d'adaptation d'impédance (70, 88), chacun desdits dispositifs terminant une extrémité respective de l'un respectif desdits câbles,
le système étant en outre **caractérisé en ce qu'**il inclut des première et seconde dites unités de distribution (38, 52, 54, 60), l'un des ports de sortie (64) de la première unité de distribution (38, 52, 54, 60) étant connecté à l'entrée de signal (102) de la seconde unité de distribution et l'un des ports d'entrée (62) de la première unité de distribution étant connecté sur la sortie de signal (104) de la seconde unité de distribution, le moyen de commutateur (90, 92, 95) de la première unité de distribution étant dans son premier état, et le moyen de commutateur ((90, 92, 95) de la seconde unité de distribution étant dans son second état.

2. Système de transmission selon la revendication 1, dans lequel chacune desdites unités de distribution inclut en outre:
un moyen d'oscillateur (98) pour appliquer un signal de pilote d'oscillation à une fréquence fixe à l'extérieur de la bande de fréquence spécifiée des porteuses RF;
un premier moyen de gain commandable interposé entre ledit moyen de commutateur (90, 92, 95) et ladite sortie de signal (104); et
un second moyen de gain commandable interposé entre ladite entrée de signal (102) et ledit moyen de commutateur (90, 92, 95),
dans lequel ledit moyen de commutateur, lorsqu'il est dans son premier état, est en outre efficace pour coupler ledit moyen d'oscillateur (98) sur ladite voie de transmission (95); et dans lequel
chacune desdites unités de distribution (30, 52, 54, 60) inclut en outre un moyen de commande de gain (112) qui est sensible au niveau dudit signal de pilote pour commander le gain desdits premier et second moyens de gain.

3. Système selon la revendication 2, dans lequel ledit moyen de commutateur (90, 92, 94) dans chacune desdites unités de distribution présente par défaut son premier état et est sensible à l'apparition dudit signal de pilote au niveau de ladite entrée de signal (102) pour passer dans son second état.

4. Système selon la revendication 2 ou 3, dans lequel ledit premier moyen de gain commandable inclut un premier atténuateur variable (116), ledit second moyen de gain commandable inclut un second atténuateur variable (106) et un amplificateur (108) présentant un gain fixe qui est connecté à la sortie du second atténuateur variable (106), et ledit moyen de commande de gain est couplé à la sortie dudit amplificateur (108) ainsi qu'aux dits premier et second atténuateurs variables (116, 106).

5. Système selon la revendication 4, dans lequel lesdits premier et second atténuateurs variables (116, 106) sont sensiblement identiques et chacune desdites unités de distribution inclut en outre un amplificateur (108) qui présente un gain égal au gain fixe de l'amplificateur (108) dudit second moyen de gain commandable et qui est connecté entre ledit moyen de combineur (72) et ledit moyen de commutateur (90, 92, 94).

6. Système selon l'une quelconque des revendications 2 à 5, dans lequel ladite unité de distribution (38, 52, 54, 60) inclut en outre un moyen de couplage directionnel (100) pour coupler ledit moyen d'oscillateur (98) sur ladite voie de transmission (95) et dans lequel ledit moyen de commutateur (90, 92, 94) est efficace pour enlever de la puissance depuis ledit moyen d'oscillateur (98) lorsque ledit moyen de commutateur (90, 92, 94) est dans son second état.

7. Système selon l'une quelconque des revendications précédentes, dans lequel ladite unité de distribution (38, 52, 54) inclut en outre un moyen pour indiquer l'état dudit moyen de commutateur (90, 92, 94).

8. Système selon l'une quelconque des revendications précédentes, dans lequel ladite unité de distribution (38, 52, 54, 60) inclut en outre un moyen d'égalisation de signal (96) qui est interposé dans ladite voie de transmission (95).

9. Système selon l'une quelconque des revendications precédentes, dans lequel il y a un nombre égal desdits ports d'entrée et de sortie (62, 64) dans ladite unité de distribution (38, 52, 54, 60).

10. Système selon l'une quelconque des revendications précédentes, dans lequel lesdits câbles (66, 68, 121, 123) incluent des câbles filaires en paire torsadée et lesdits dispositifs d'adaptation d'impédance incluent des symétriseurs, ledit système comprenant en outre un premier groupe de symétriseurs (70) agencé en tant que partie de ladite unité de distribution et localisé entre ledit moyen de combineur (72) et ladite pluralité de ports d'entrée (62);
un second groupe de symétriseurs (88) agencé en tant que partie de ladite unité de distribution et localisé entre ledit moyen de séparateur (84) et ladite pluralité de ports de sortie (64); et
un troisième groupe de symétriseurs (34, 36) localisé au niveau des extrémités desdits câbles à distance de ladite unité de distribution.

11. Système selon la revendication 10, dans lequel les câbles de ladite pluralité de câbles en paire torsadée sont tous du même type et sont soit à l'intérieur d'une première plage de longueur, soit à l'intérieur d'une seconde plage de longueur égal à la longueur maximum de ladite première plage de longueur plus une troisième plage de longueur, le système incluant en outre un moyen de simulateur de câble (200, 202) qui est connecté aux symétriseurs du troisième groupe de symétriseurs (34, 36), qui sont connectés aux câbles de la seconde plage de longueur pour simuler une longueur de câble égale à la longueur maximum de ladite troisième plage de longueur.

12. Système selon l'une quelconque des revendications 1 à 9, dans lequel lesdits câbles incluent des câbles à fibre optique et lesdits dispositifs d'adaptation d'impédance incluent un émetteur-récepteur opto-électrique.

13. Système selon l'une quelconque des revendications 1 à 9, dans lequel lesdits câbles incluent des câbles coaxiaux et lesdits dispositifs d'adaptation d'impédance incluent un transformateur (126).

14. Système selon l'une quelconque des revendications précédentes, incluant:
un circuit de validation de signal qui est prévu au niveau d'au moins l'une de ladite pluralité de sorties (118, 120), ledit circuit de validation de signal étant constitué par une source de puissance DC (318) et par un combineur et ainsi,
un signal DC est combiné avec un signal d'entrée sur la sortie.

15. Système selon l'une quelconque des revendications précédentes, incluant un circuit de simulateur de câble qui est prévu au niveau d'au moins l'une de ladite pluralité de sorties (118, 120), ledit circuit de simulateur de câble étant constitué par un simulateur de câble en connexion interne (202), par un simulateur de câble en connexion externe (200) et par un commutateur (320, 322, 328, 326) et ainsi, les simulateurs de câbles en connexions interne et externe (202, 200) peuvent être commutés dans un circuit entre une source et l'un desdits câbles s'étendant entre l'un desdits ports d'unité de distribution respectifs et l'une de ladite pluralité respective de sorties.

16. Unité de distribution (38, 52, 54, 60) pour une utilisation dans un système de distribution de signal large bande dans lequel le système inclut une pluralité de sorties (118, 120) chaque sortie étant connectée à une source ou à une destination de signaux large bande, et une pluralité de câbles (66, 68) qui s'étendent entre les sorties (118, 120) et l'unité de distribution pour transporter des signaux large bande modulés sur des porteuses RF à l'intérieur d'une bande de fréquence spécifiée entre les sorties, l'unité de distribution (38, 52, 54, 60) comprenant:
une pluralité de ports d'entrée (62) dont chacun est adapté pour être connecté à l'un respectif desdits câbles;
un pluralité de ports de sortie (64);
un combineur (72) qui comporte une pluralité de bornes d'entrée et qui comporte une borne de sortie sur laquelle est appliquée un signal combiné qui est une combinaison additive de tous les signaux qui apparaissent au niveau desdits ports d'entrée (62);
un séparateur (84) qui comporte une borne d'entrée et une pluralité de bornes de sortie et sur toutes ces bornes, un signal qui apparaît au niveau de la borne d'entrée de séparateur est appliqué;
une voie de transmission (95) qui est couplée entre ladite borne de sortie de combineur et ladite borne d'entrée de séparateur,
**caractérisée par**:
une première pluralité de dispositifs d'adaptation d'impédance (70) dont chacun a son extrémité équilibrée qui est connectée à l'un respectif desdits ports d'entrée (62);
une seconde pluralité de dispositifs d'adaptation d'impédance (88) dont chacun à son extrémité déséquilibrée qui est connectée à l'une respective desdites bornes de sortie de séparateur;
une entrée de signal (102) qui est adaptée pour être couplée à un câble qui s'étend jusqu'à un port de sortie d'une autre dite unité de distribution (38, 82, 54, 60) de construction identique;
une sortie de signal (104) qui est adaptée pour être couplée à un câble qui s'étend jusqu'à un port d'entrée (62) de ladite autre unité de distribution; et
un moyen de commutateur (90, 92, 94) qui peut fonctionner selon soit un premier état, soit un second état, ledit moyen de commutateur (90, 92, 94) étant couplé à ladite voie de transmission (95), à ladite borne de sortie de combineur, à ladite borne d'entrée de séparateur, à ladite entrée de signal (102) et à ladite sortie de signal (104), ledit moyen de commutateur (90, 92, 94), lorsqu'il est dans son premier état étant efficace pour coupler ladite voie de transmission (95) sur ladite borne de sortie de combineur (72) et sur ladite borne d'entrée de séparateur et ledit moyen de commutateur (90, 92, 94), lorsqu'il est dans son second état, étant efficace pour coupler ladite borne de sortie de combineur sur ladite sortie de signal (104) et pour coupler ladite entrée de signal (102) sur ladite borne d'entrée de séparateur; et
**caractérisée en outre en ce que**:
chaque borne d'entrée combinée est connectée à l'extrémité déséquilibrée de l'un respectif de ladite première pluralité de dispositifs d'adaptation d'impédance (70);
chaque port de sortie (64) qui est connecté à l'extrémité équilibrée de l'un respectif de ladite seconde pluralité de dispositifs d'adaptation d'impédance (88) et chacun est adapté pour être connecté à l'un respectif desdits câbles.

17. Unité de distribution selon la revendication 16, incluant un oscillateur (98) qui applique un signal de pilote de fréquence fixe à l'extérieur de la bande de fréquence spécifiée des porteuses RF; et un moyen de commande de commutateur (114) qui est sensible à la présence dudit signal de pilote au niveau de ladite entrée de signal (102) pour commander ledit moyen de commutateur (90, 92, 94) afin qu'il prenne son second état,
dans lequel l'état par défaut dudit moyen de commutateur (90, 92, 94) est son premier état et dans lequel ledit moyen de commutateur (90, 92, 94), lorsqu'il est dans son premier état, est en outre efficace pour coupler ledit signal de pilote de fréquence fixe d'oscillateur sur ladite voie de transmission (95).

18. Unité de distribution selon la revendication 17, incluant:
un premier moyen de gain commandable qui est couplé entre ladite sortie de signal (104) et ledit moyen de commutateur (90, 92, 94);
un second moyen de gain commandable qui est couplé entre ladite entrée de signal (102) et ledit moyen de commutateur; et
un moyen de commande de gain (112) qui comporte une entrée qui est couplée entre ledit second moyen de gain commandable et ledit moyen de commutateur et qui est sensible au niveau dudit signal de pilote pour commander le gain de à la fois lesdits premier et second moyens de gain (106, 116).

19. Unité de distribution selon la revendication 17 ou 18, incluant un coupleur directionnel (116) qui comporte une entrée qui est interposé entre ledit second moyen de gain et ledit moyen de commutateur (90, 92, 94) et une sortie qui est couplée à l'entrée dudit moyen de commande de gain; et
dans lequel ledit moyen de commande de gain (112) inclut un filtre passe-bande (162) qui est accordé pour laisser passer ledit signal de pilote, ledit filtre passe-bande (162) étant connecté en série entre l'entrée dudit moyen de commande de gain -et le reste dudit moyen de commande de gain.

20. Unité de distribution selon la revendication 18 ou 19, dans laquelle chacun desdits premier et second moyens de gain (132, 136) inclut un atténuateur variable (106, 116) comportant une diode p-i-n dont la cathode est connectée à l'entrée ou la sortie de signal respective (102, 104) et dont l'anode est connectée au moyen de commutateur (90, 92, 94), et une source de courant de polarisation connectée à l'anode de la diode p-i-n; et
le moyen de commande de gain (112) comporte une sortie qui est connectée à la cathode de la diode p-i-n afin de faire varier le courant de polarisation au travers.

21. Unité de distribution selon la revendication 19 ou 21, dans laquelle ledit moyen de commande de commutateur (114) est couplé audit filtre passe-bande (162) à distance de l'entrée dudit moyen de commande de gain.

22. Unité de distribution selon l'une quelconque des revendications 16 à 21, dans laquelle l'unité de distribution inclut en outre un moyen d'égalisation de signal (96) qui est interposé dans ladite voie de transmission (95).

23. Unité de distribution selon l'une quelconque des revendications 16 à 22, incluant un moyen pour indiquer l'état dudit moyen de commutateur.

24. Unité de distribution selon l'une quelconque des revendications 16 à 23, incluant:
une première diode émettrice de lumière (188, 190);
une seconde diode émettrice de lumière (188, 190);
une première source de tension qui est couplée aux anodes des diodes émettrices de lumière;
une seconde source de tension à un niveau inférieur au niveau de la première source de tension, couplée aux cathodes des diodes émettrices de lumière;
un premier moyen de commutation commandable (192, 194) qui est connecté en série avec ladite première diode émettrice de lumière (188, 190) et qui comporte une entrée de commande;
un second moyen de commutation commandable (192, 194) qui est connecté en série avec ladite seconde diode émettrice de lumière (192, 194) et qui comporte une entrée de commande; et
un moyen pour coupler ledit moyen de commande de commutateur (90, 92, 94) sur les entrées de commande desdits premier et second moyens de commutation commandables (192, 194);
dans laquelle lesdits premier et second moyens de commutation commandables (192, 194) répondent à des signaux de niveaux différents au niveau de leurs entrées de commande pour constituer des voies de courant pour leurs diodes émettrices de lumière respectives (190, 188) et ledit moyen de commande de commutateur (90, 92, 94) applique lesdits signaux de niveaux différents correspondant à des états respectifs dudit moyen de commutateur (90, 92, 94).
